# EUROPEAN PATENT APPLICATION

(11) **EP 4 465 121 A1**
(43) Date of publication of application: **20.11.2024**
(21) Application number: 22968848.6
(22) Date of filing: 20.12.2022
(51) Int. Cl.: G02F 1/133

(54) **DISPLAY PANEL AND DISPLAY APPARATUS THEREWITH**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: SHANG, Yanyang, Beijing 100176 (CN); CHEN, Youchun, Beijing 100176 (CN); LI, Shuo, Beijing 100176 (CN)
(74) Representative: Hoffmann Eitle
(86) International application number: PCT/CN2022/140344
(87) International publication number: WO 2024/130545

(57) **Abstract**

A display panel, comprising a substrate (110), a drive circuit layer (120) and a pixel defining layer (130), wherein the drive circuit layer (120) is arranged on the substrate (110); the orthographic projection of the drive circuit layer (120) on the substrate (110) encloses a plurality of light-transmitting regions (S); the pixel defining layer (130) is arranged on the side of a pixel circuit (121) that is away from the substrate (110); and the pixel defining layer (130) is provided with a plurality of photosensitive openings (131), the orthographic projections of the photosensitive openings (131) on the substrate (110) being located in the light-transmitting regions (S), and the shapes of the orthographic projections of the photosensitive openings (131) on the substrate (110) being substantially the same as the shapes of the light-transmitting regions (S).

## Description

### TECHNICAL FIELD

The present disclosure relates to the field of display technologies, and in particular, to a display panel and a display apparatus therewith.

### BACKGROUND

With the rapid development of display technologies, display apparatuses have gradually spread in people's lives. Due to the advantages of self-illumination, low power consumption, wide viewing angle, fast response speed, high contrast, and flexible display, an organic light-emitting diode (OLED) is widely used in smart products such as mobile phones, televisions, and notebook computers.

### SUMMARY

In an aspect, a display panel is provided. The display panel includes a substrate, a driving circuit layer and a pixel defining layer. The driving circuit layer is arranged on the substrate, and an orthographic projection of the driving circuit layer on the substrate defines a plurality of light-transmissive zones. The pixel defining layer is arranged on a side of the driving circuit layer away from the substrate, and the pixel defining layer is provided therein with a plurality of light-irradiating openings; and an orthogonal projection of a light-irradiating opening on the substrate is located in a light-transmissive zone, and a shape of the orthogonal projection of the light-irradiating opening on the substrate is substantially same as a shape of the light-transmissive zone.

In some embodiments, the driving circuit layer includes a plurality of pixel circuits and a plurality of data lines. The plurality of pixel circuits are arranged in multiple rows and multiple columns, where a row of pixel circuits is divided into a plurality of pixel circuit groups, and a pixel circuit group includes two adjacent pixel circuits; and in a same pixel circuit group, two pixel circuits are substantially symmetrical about a first axis line, the first axis line extends along a first direction, and the first direction is a column direction in which the plurality of pixel circuits are arranged. The plurality of data lines substantially extend along the first direction, where the plurality of data lines are divided into a plurality of data line groups, and a data line group includes two adjacent data lines; and the two data lines in the data line group are respectively electrically connected to two pixel circuits in a pixel circuit group. The light-transmissive zone is located between two data lines in a same data line group, and the light-irradiating opening is substantially parallel to opposite edges of orthographic projections of first set line segments of the two data lines in the same data line group on the substrate.

In some embodiments, the data lines each include first straight line segments and first bent segments that are alternately connected, and in the same data line group, first bent segments of the two data lines are bent toward directions away from each other; and the first set line segments each include at least a portion of a first bent segment.

In some embodiments, the first bent segment includes a first data trace segment, a second data trace segment, and a third data trace segment that are connected in sequence, the first data trace segment and the third data trace segment are respectively connected to first straight line segments on both sides of the first bent segment, an extending direction of the second data trace segment is substantially same as an extending direction of the first straight line segments, and the second data trace segment is farther away from first bent segments of the other data line in the same data line group than the first straight line segments; and the first set line segment includes a portion of the second data trace segment, and includes a portion of the first data trace segment or a portion of the third data trace segment.

In some embodiments, the driving circuit layer further includes first scanning signal lines and second scanning signal lines. The first scanning signal lines extend substantially along a second direction; and the second scanning signal lines extend substantially along the second direction. The light-transmissive zone is located between a first scanning signal line and a second scanning signal line that are adjacent; and the light-irradiating opening is substantially parallel to opposite edges of an orthographic projection of a second set line segment of the first scanning signal line on the substrate, and the light-irradiating opening is substantially parallel to opposite edges of an orthographic projection of a third set line segment of the second scanning signal line on the substrate.

In some embodiments, the first scanning signal line includes second straight line segments and second bent segments that are alternately connected, the second scanning signal line includes third straight line segments and third bent segments that are alternately connected, and a second bent segment and a third bent segment that are adjacent are bent toward directions away from each other; and the second set line segment includes at least a portion of the second bent segment, and the third set line segment includes the third bent segment and a portion of the third straight line segment.

In some embodiments, the second bent segment includes a first reset trace segment, a second reset trace segment, a third reset trace segment, a fourth reset trace segment, a fifth reset trace segment, a sixth reset trace segment, and a seventh reset trace segment that are connected in sequence. The first reset trace segment and the seventh reset trace segment are respectively connected to second straight line segments on both sides of the second bent segment; an extending direction of the second reset trace segment, the fourth reset trace segment and the sixth reset trace segment is substantially same as an extending direction of the second straight line segments, and the second reset trace segment and the sixth reset trace segment are farther away from the second scanning signal line than the second straight line segments; the fourth reset trace segment is farther away from the adjacent second scanning signal line than the second reset trace segment and the sixth reset trace segment; and the second set line segment includes the fourth reset trace segment, a portion of the third reset trace segment, and a portion of the fifth reset trace segment.

In some embodiments, the third bent segment includes a first scanning trace segment, a second scanning trace segment, and a third scanning trace segment. The first scanning trace segment and the third scanning trace segment are respectively connected to third straight line segments on both sides of the third bent segment, and an extending direction of the second scanning trace segment is substantially same as an extending direction of the third straight line segments, and the second scanning trace segment is farther away from the adjacent first scanning signal line than the third straight line segments.

In some embodiments, a minimum distance between a boundary of the orthogonal projection of the light-irradiating opening on the substrate and a boundary of the light-transmissive zone is greater than or equal to 1 µm.

In some embodiments, the pixel defining layer is further provided therein with a plurality of pixel openings, and the plurality of pixel openings include a plurality of first pixel openings, a plurality of second pixel openings, a plurality of third pixel openings, and a plurality of fourth pixel openings. The plurality of first pixel openings and the plurality of second pixel openings are arranged in an array in multiple rows and multiple columns, each row includes multiple first pixel openings and multiple second pixel openings that are arranged alternately along a second direction, and each column includes multiple first pixel openings and multiple second pixel openings that are arranged alternately along a first direction; and the plurality of third pixel openings and the plurality of fourth pixel openings are arranged in an array in multiple rows and multiple columns, each row includes multiple third pixel openings and multiple fourth pixel openings that are arranged alternately along the second direction, and each column includes multiple third pixel openings and multiple fourth pixel openings that are arranged alternately along the first direction; and a third pixel opening is located between first pixel openings and second pixel openings that are arranged in two rows and two columns, and a fourth pixel opening adjacent thereto is located between first pixel openings and second pixel openings that are arranged in another two rows and two columns.

In some embodiments, the light-irradiating opening is located between a first pixel opening and a second pixel opening that are adjacent in the second direction.

In some embodiments, an orthogonal projection, on the substrate, of each of the first pixel opening, the second pixel opening, the third pixel opening, and the fourth pixel opening is substantially circular.

In some embodiments, the light-transmissive zone includes a first folded edge, a first straight edge, a second folded edge, and a second straight edge that are connected in sequence; the first folded edge includes a plurality of first straight sub-edges connected in sequence, and the second folded edge includes a plurality of second straight sub-edges connected in sequence; and the first straight edge and the second straight edge are an edge closest to a third pixel opening adjacent to the light-transmissive zone and an edge closest to a fourth pixel opening adjacent to the light-transmissive zone, respectively.

The light-irradiating opening includes a third folded edge, a third straight edge, a fourth folded edge, and a fourth straight edge that are connected in sequence; the third folded edge is proximate to the first pixel opening and includes a plurality of third straight sub-edges connected in sequence; and the fourth folded edge is proximate to the second pixel opening and includes a plurality of fourth straight sub-edges connected in sequence.

The third straight edge is substantially parallel to the first straight edge, and the fourth straight edge is substantially parallel to the second straight edge; the plurality of third straight sub-edges in the third folded edge are in one-to-one correspondence with and substantially parallel to the plurality of first straight sub-edges in the first folded edge; and a number of the plurality of fourth straight sub-edges in the fourth folded edge is less than a number of the plurality of second straight sub-edges in the second folded edge, and each fourth straight sub-edge is substantially parallel to a second straight sub-edge.

In some embodiments, an orthogonal projection, on the substrate, of each of the first pixel opening, the third pixel opening, and the fourth pixel opening is substantially circular. An outer contour of the second pixel opening includes a first curved edge and a second curved edge, both ends of the first curved edge are respectively connected to both ends of the second curved edge, and two connection points of the first curved edge and the second curved edge are a first connection point and a second connection point; and a connection line between the first connection point and the second connection point is a first line segment; a length of the first line segment is a maximum dimension of the second pixel opening, and divides the second pixel opening into a first sub-portion including the first curved edge and a second sub-portion including the second curved edge; an area of the first sub-portion is greater than an area of the second sub-portion.

In some embodiments, the light-transmissive zone includes a first folded edge, a first straight edge, a second folded edge, and a second straight edge that are connected in sequence; the first folded edge includes a plurality of first straight sub-edges connected in sequence, and the second folded edge includes a plurality of second straight sub-edges connected in sequence; and the first straight edge and the second straight edge are an edge closest to a third pixel opening adjacent to the light-transmissive zone and an edge closest to a fourth pixel opening adjacent to the light-transmissive zone, respectively.

The light-irradiating opening includes a third folded edge, a third straight edge, a fourth folded edge, and a fourth straight edge that are connected in sequence; the third folded edge is proximate to the first pixel opening and includes a plurality of third straight sub-edges connected in sequence; and the fourth folded edge is proximate to the second pixel opening and includes a plurality of fourth straight sub-edges connected in sequence.

The third straight edge is substantially parallel to the first straight edge, and the fourth straight edge is substantially parallel to the second straight edge; the plurality of third straight sub-edges in the third folded edge are in one-to-one correspondence with and substantially parallel to the plurality of first straight sub-edges in the first folded edge; and each fourth straight sub-edge is substantially parallel to a second straight sub-edge. In a case where the fourth folded edge is opposite to the second curved edge of the second pixel opening, the plurality of fourth straight sub-edges in the fourth folded edge are in one-to-one correspondence with the plurality of second straight sub-edges in the second folded edge; and in a case where the fourth folded edge is non-opposite to the second curved edge of the second pixel opening, a number of the plurality of fourth straight sub-edges in the fourth folded edge is less than a number of the plurality of second straight sub-edges in the second folded edge.

In some embodiments, the display panel further includes a touch layer arranged on a side of the pixel defining layer away from the substrate. The touch layer includes a plurality of touch lines, and an orthographic projection of the plurality of touch lines on the substrate is staggered from an orthogonal projection of the pixel openings and the light-irradiating openings on the substrate; and the plurality of touch lines are arranged crosswise to form a mesh structure. There exists at least such one row of light-irradiating openings that there is no touch line between the row of light-irradiating openings and both first pixel openings and second pixel openings adjacent thereto in the second direction.

In some embodiments, first pixel openings and second pixel openings in a same row are divided into a plurality of pixel opening groups, and each pixel opening group includes a first pixel opening and a second pixel opening that are adjacent; and in a same pixel opening group, a first pixel opening and a second pixel opening is provided therebetween with a touch line; and there is no touch line between a first pixel opening and a second pixel opening that are adjacent and belong to different pixel opening groups in the second direction.

In some embodiments, in a case where there is no touch line between a light-irradiating opening and a pixel opening, a distance between the light-irradiating opening and the pixel opening is a first distance; in a case where there is a touch line between a light-irradiating opening and a pixel opening, a distance between the light-irradiating opening and the pixel opening is a second distance; and the first distance is less than the second distance.

In some embodiments, the display panel further includes a black matrix arranged on a side of the pixel defining layer away from the substrate. The black matrix is provided therein with a plurality of first avoidance openings and a plurality of second avoidance openings. An orthogonal projection of a pixel opening on the substrate is located within a range of an orthogonal projection of a first avoidance opening on the substrate; and an orthogonal projection of a light-irradiating opening on the substrate is located within a range of an orthogonal projection of a second avoidance opening on the substrate.

In some embodiments, an average distance between a boundary of the orthogonal projection of the first avoidance opening on the substrate and a boundary of the orthogonal projection of the pixel opening on the substrate is in a range of 2 µm to 6 µm, inclusive; and/or a distance between a boundary of the orthogonal projection of the second avoidance opening on the substrate and a boundary of the orthogonal projection of the light-irradiating opening on the substrate is in a range of 0 µm to 3.2 µm, inclusive.

In some embodiments, a distance between the first avoidance opening and the second avoidance opening is greater than or equal to a first preset value, and the first preset value is a process limit value allowing the first avoidance opening to be separated from the second avoidance opening.

In some embodiments, the display panel further includes a color film arranged on a side of the black matrix away from the substrate. The color film includes a plurality of filter patterns, and the orthogonal projection of the pixel opening on the substrate is located within a range of an orthographic projection of a filter pattern on the substrate. A distance between a boundary of the orthographic projection of the filter pattern on the substrate and a boundary of the orthogonal projection of the first avoidance opening on the substrate is greater than or equal to 4.5 µm.

In another aspect, a display apparatus is provided. The display apparatus includes the display panel according to any of the above embodiments and a photosensitive device. The display panel includes a light-exit side and a non-light-exit side arranged opposite thereto; and the photosensitive device is arranged on the non-light-exit side of the display panel.

### BRIEF DESCRIPTION OF THE DRAWINGS

In order to describe technical solutions in the present disclosure more clearly, the accompanying drawings to be used in some embodiments of the present disclosure will be introduced briefly; obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural view of a display apparatus, in accordance with some embodiments;
FIG. 2 is a sectional view of a display apparatus, in accordance with some embodiments;
FIG. 3 is an exploded view of a display apparatus, in accordance with some embodiments;
FIG. 4 is a sectional view taken along the A-A' line in FIG. 3;
FIG. 5 is a top view of a display panel in which a driving circuit layer is coated with a pixel defining layer, in accordance with some embodiments;
FIG. 6 is a top view of a driving circuit layer of a display panel, in accordance with some embodiments;
FIG. 7 is a top view of a pixel circuit of a display panel, in accordance with some embodiments;
FIG. 8 is a structural view of a data line, in accordance with some embodiments;
FIG. 9 is a structural view of a first scanning signal line, in accordance with some embodiments;
FIG. 10 is a structural view of a second scanning signal line, in accordance with some embodiments;
FIG. 11A is a top view of a pixel defining layer and a black matrix, in accordance with some embodiments;
FIG. 11B is another top view of a pixel defining layer and a black matrix, in accordance with some embodiments;
FIG. 12 is yet another top view of a pixel defining layer and a black matrix, in accordance with some embodiments;
FIG. 13A is a partially enlarged view of the box A in FIG. 11A;
FIG. 13B is a partially enlarged view of the box B in FIG. 11A;
FIG. 14A is a partially enlarged view of the box C in FIG. 11B;
FIG. 14B is a partially enlarged view of the box D in FIG. 11B;
FIG. 15 is a partially enlarged view of the box C in FIG. 12;
FIG. 16 is an enlarged view of a light-irradiating opening and a light-transmissive zone, in accordance with some embodiments;
FIG. 17 is another enlarged view of a light-irradiating opening and a light-transmissive zone, in accordance with some embodiments;
FIG. 18 is yet another enlarged view of a light-irradiating opening and a light-transmissive zone, in accordance with some embodiments;
FIG. 19 is a top view of pixel openings, light-irradiating openings and a touch layer, in accordance with some embodiments;
FIG. 20 is a top view of pixel openings, light-irradiating openings and touch lines, in accordance with some embodiments;
FIG. 21 is an enlarged view of two pixel openings and one light-irradiating opening in a pixel opening group, and a touch line, in accordance with some embodiments; and
FIG. 22 is a top view of pixel openings, light-irradiating openings, first avoidance openings, second avoidance openings, and filter patterns, in accordance with some embodiments.

### DETAILED DESCRIPTION

The technical solutions in some embodiments of the present disclosure will be described clearly and completely with reference to the accompanying drawings; however, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating a number of indicated technical features. Thus, features defined with "first" or "second" may explicitly or implicitly include one or more of the features. In the description of the embodiments of the present disclosure, the term "a/the plurality of" or "multiple" means two or more unless otherwise specified.

In the description of some embodiments, the expressions "coupled," "connected," and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled" indicates that two or more components are in direct physical or electrical contact with each other. The term "coupled" or "communicatively coupled" may also mean that two or more components are not in direct contact with each other but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes the following three combinations: only A, only B, and a combination of A and B.

As used herein, the term "if" is, optionally, construed as "when" or "in a case where" or "in response to determining that" or "in response to detecting," depending on the context. Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event]."

The use of the phrase "applicable to" or "configured to" herein means an open and inclusive expression, which does not exclude devices that are applicable to or configured to perform additional tasks or steps.

In addition, the use of the phase "based on" is meant to be open and inclusive, since a process, step, calculation or other action that is "based on" one or more of the stated conditions or values may, in practice, be based on additional conditions or value beyond those stated.

The term such as "about," "substantially," or "approximately" as used herein includes a stated value and an average value within an acceptable range of deviation of a particular value. The acceptable range of deviation is determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views that are schematic illustrations of idealized embodiments. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

It should be understood that in an evaporation process of different materials, the design value and the actual value will have a preset deviation, and the value of the preset deviation can be obtained according to the experiment. Therefore, the design value can be calculated according to the actual value and the value of the preset deviation. For example, the value of a preset deviation of a pixel defining layer is -1 µm, i.e., the actual value of the diameter of an opening of the pixel defining layer is less than the design value thereof by 1 µm; the value of a preset deviation of a black matrix is 1.2 µm, i.e., the actual value of the diameter of an opening of the black matrix is greater than the design value thereof by 1.2 µm; and the value of a preset deviation of a color film is 3 µm, i.e., the actual value of the diameter of the color film is greater than the design value thereof by 3 µm. The embodiments of the present disclosure are illustrated by taking actual values as examples herein.

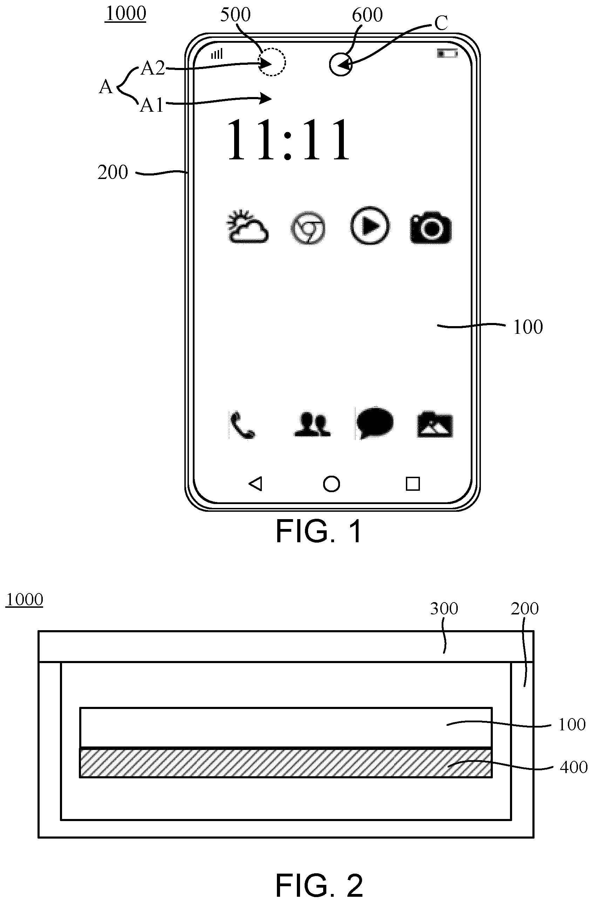

As shown in FIG. 1, some embodiments of the present disclosure provide a display apparatus 1000, and the display apparatus 1000 may be any apparatus that can display an image whether in motion (e.g., video) or stationary (e.g., a still image), and whether textual or pictorial.

For example, the display apparatus 1000 may be any product or component having a display function, such as a television, a notebook computer, a tablet computer, a mobile phone, a personal digital assistant (PDA), a navigator, a wearable device, or a virtual reality (VR) device.

In some embodiments, as shown in FIG. 1, the display apparatus 1000 includes a display panel 100.

For example, as shown in FIG. 1 and FIG. 2, the display apparatus 1000 may further include a housing 200, a cover plate 300, a circuit board 400, a photosensitive device 500, a camera 600 and other electronic accessories.

As shown in FIG. 2, a longitudinal section of the housing 200 may be, for example, U-shaped. The display panel 100 and the circuit board 400 are arranged in the housing 200, and the cover plate 300 is arranged at an opening of the housing 200.

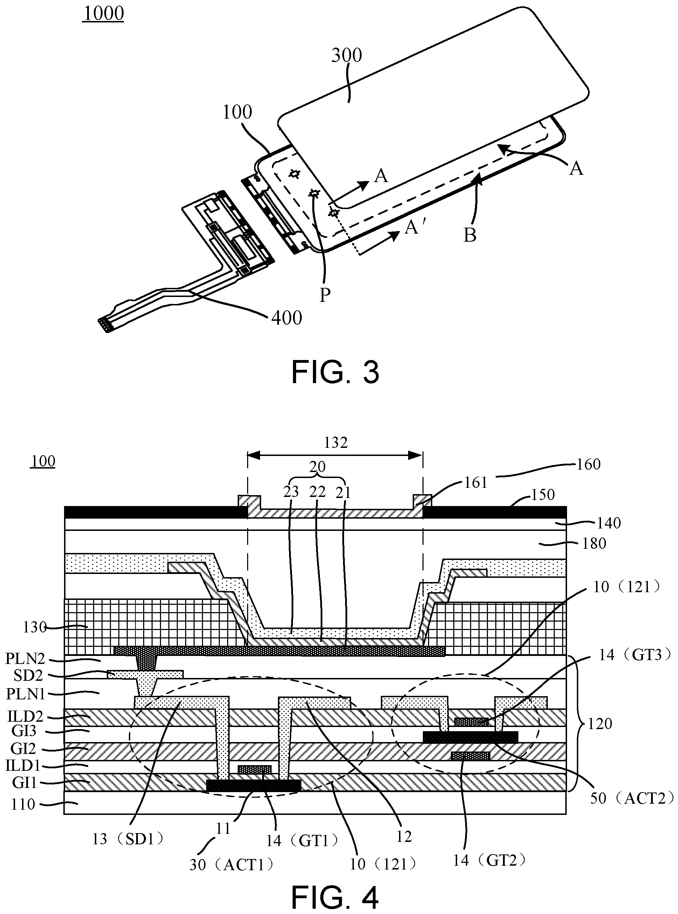

As shown in FIG. 2 and FIG. 3, the circuit board 400 may be bonded to the display panel 100 at the end of the display panel 100 and bent to the back side of the display panel 100, which is beneficial to the narrow frame design of the display apparatus 1000.

As shown in FIG. 1 and FIG. 3, the photosensitive device 500 and the camera 600 may be, for example, integrated under the display panel 100 to increase a screen-to-body ratio thereof. Here, the photosensitive device 500 includes at least one of an infrared sensor, a distance sensor, a fingerprint identification module and a brightness adjustment module.

Type of the display panel 100 varies, which may be selected according to actual needs.

For example, the display panel 100 may be an organic light-emitting diode (OLED) display panel, or a quantum dot light-emitting diode (QLED) display panel, which is not specifically limited in embodiments of the present disclosure.

Some embodiments of the present disclosure will be schematically described below by considering an example in which the display panel 100 is the OLED display panel.

In some embodiments, referring to FIG. 3, the display panel 100 has a display region A and a peripheral region B arranged on at least one side of the display region A. FIG. 3 illustrates an example in which the peripheral region B is arranged around the display region A.

Here, the display region A is a region for displaying images, and is configured to be provided therein with a plurality of sub-pixels P. The peripheral region B is a region where no image is displayed therein, and is configured to be provided therein with a display driving circuit, for example, a gate driving circuit and a source driving circuit.

In some examples, referring to FIG. 1, the display region A may include, for example, a main display region A1 and a light-irradiating region A2, and the main display region A1 surrounds the light-irradiating region A2. Here, the photosensitive device 500 is located under the light-irradiating region A2 of the display panel 100.

Here, referring to FIG. 1 and FIG. 3, the light-irradiating region A2 may be located at the top of the display region A, that is, a portion of the display region A that is relatively far away from a bonding portion of the display panel 100, or may be located at other positions of the display region A, which will not be described in detail in the embodiments of the present disclosure.

It will be noted that the shape of the light-irradiating region A2 may be any one of circle, polygon and irregular figure, which will not be described in detail in the embodiments of the present disclosure.

In some embodiments, referring to FIG. 1, the display panel 100 may further have a camera region C, and the camera 600 is located under the camera region C of the display panel 100.

Here, the display region A may, for example, surround the camera region C, and the camera region C may be located at the top of the display region A, that is, the portion of the display region A that is relatively far away from the bonding portion of the display panel 100, or may be located at other positions of the display region A, which will not be described in detail in the embodiments of the present disclosure.

In related art, the integrated transmittance of the region (the light-irradiating region) where the photosensitive device is located is low, external ambient light that the photosensitive device is capable of receiving is less, and the photosensitivity is low, which has adverse effects on the automatic brightness adjustment function and touch function of the display panel.

The integrated transmittance herein refers to the product of the transmittance of the display panel 100 and the aperture ratio of light-irradiating openings in the light-irradiating region A2.

In light of this, referring to FIG. 4, some embodiments of the present disclosure provide a display panel 100, and the display panel 100 includes a substrate 110, a driving circuit layer 120 and a pixel defining layer 130.

Referring to FIG. 4, type of the substrate 110 varies, which may be selected according to actual needs.

For example, the substrate 110 may be a rigid substrate. The rigid substrate may be, for example, a glass substrate or a polymethyl methacrylate (PMMA) substrate.

For example, the substrate 110 may be a flexible substrate. For example, the flexible substrate may be a polyethylene terephthalate (PET) substrate, a polyethylene naphthalate (PEN) substrate or a polyimide (PI) substrate.

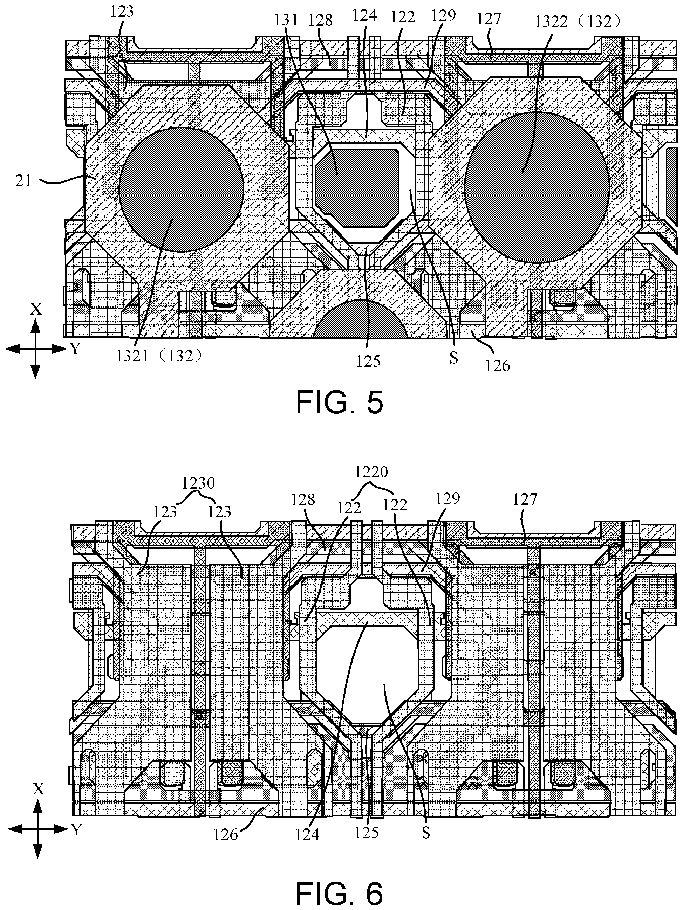

Referring to FIG. 4 and FIG. 5, the driving circuit layer 120 is arranged on the substrate 110. An orthographic projection of the driving circuit layer 120 on the substrate 110 defines a plurality of light-transmissive zones S. Here, the shape of the light-transmissive zone S may be, for example, a polygon.

Referring to FIG. 4, the pixel defining layer 130 is arranged on a side of the driving circuit layer 120 away from the substrate 110.

Referring to FIG. 4 and FIG. 5, the pixel defining layer 130 is provided therein with a plurality of light-irradiating openings 131, and an orthogonal projection of a light-irradiating opening 131 on the substrate 110 is located in a light-transmissive zone S. Moreover, the shape of the orthogonal projection of the light-irradiating opening 131 on the substrate 110 is substantially the same as the shape of the light-transmissive zone S.

It will be noted that due to limitations of the process and the characteristics of the material itself, edges of corners of the light-irradiating opening 131 are arc-shaped.

Herein, "substantially the same shape" means that shapes of two objects are similar as a whole, but are not limited to being exactly the same in shape. That is, the "substantially the same shape" here includes not only a case where the overall shapes of the two are completely the same, but also a case where more than half of the shapes of the two are the same in consideration of process conditions and process avoidance. For example, there may be an absence of one or more edges that are shorter in one compared to the other. For another example, an edge of a corner is arc-shaped in one compared to the other.

In this case, since the shape of the light-irradiating opening 131 is substantially the same as that of the light-transmissive zone S, the minimum distance between any point on a boundary of the light-irradiating opening 131 and a boundary of the light-transmissive zone S may be set to a process limit value, thereby increasing the ratio of the light-irradiating opening 131 to the light-transmissive zone S, increasing the area of the light-irradiating opening 131, and thereby increasing the integrated transmittance of the light-irradiating region A2, and improving the photosensitivity of the photosensitive device 500.

Here, the process limit value may be, for example, a process limit value for the pixel defining layer 130 to cover the driving circuit layer 120 to prevent light leakage from the driving circuit layer 120.

For example, referring to FIG. 4 and FIG. 5, the minimum distance between a boundary of the orthogonal projection of the light-irradiating opening 131 on the substrate and the boundary of the light-transmissive zone S is greater than or equal to 1 µm. In this way, the pixel defining layer 130 can cover the driving circuit layer 120 to prevent light leakage from the driving circuit layer 120.

For example, as shown in FIG. 4 and FIG. 5, the minimum distance between the boundary of the orthogonal projection of the light-irradiating opening 131 on the substrate 110 and the boundary of the light-transmissive zone S is in a range of 1 µm to 2 µm, inclusive, which may effectively prevent light leakage from the driving circuit layer 120, and the area of the light-transmissive zone S may be designed to be large.

In some embodiments, as shown in FIG. 4, the driving circuit layer 120 includes a plurality of pixel circuits 121, a plurality of data lines 122 and a plurality of power supply lines 123.

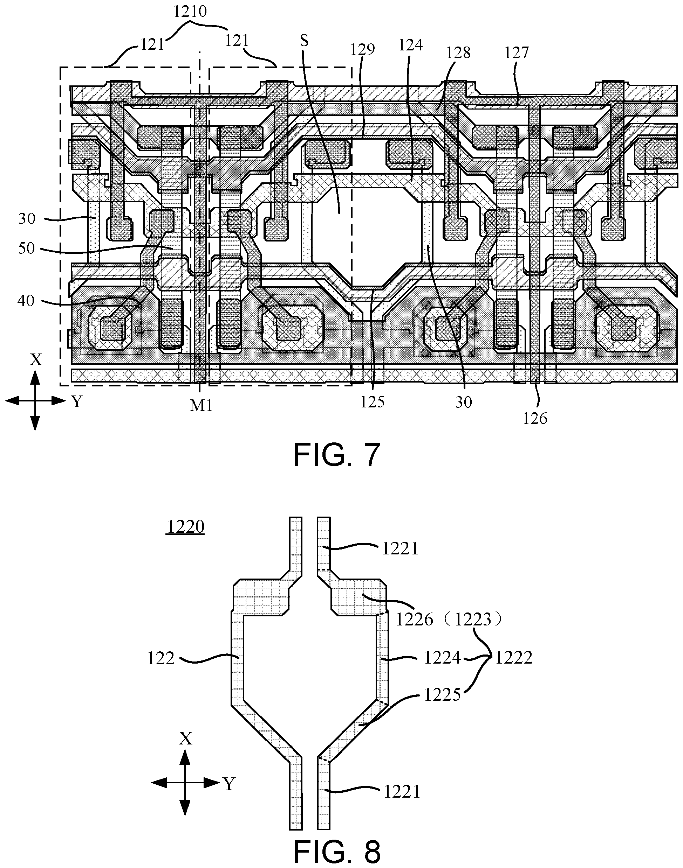

Referring to FIG. 5 and FIG. 7, the plurality of pixel circuits 121 are arranged in multiple rows and multiple columns, and a row of pixel circuits 121 is divided into a plurality of pixel circuit groups 1210. A pixel circuit group 1210 includes two adjacent pixel circuits 121. In FIG. 5, FIG. 6 and FIG. 7, only four pixel circuits 121 arranged along a row direction are used for illustration.

Here, as shown in FIG. 7, in a same pixel circuit group 1210, two pixel circuits 121 are substantially symmetrical about a first axis line M1, the first axis line M1 extends along a first direction X, and the first direction X is a column direction in which the plurality of pixel circuits 121 are arranged.

As shown in FIG. 6, the data line 122 and the power supply line 123 substantially extend along the first direction X, and the plurality of data lines 122 may be divided into a plurality of data line groups 1220, and a data line group 1220 includes two adjacent data lines 122. The plurality of power supply lines 123 may be divided into a plurality of power supply line group 1230, and a power supply line group 1230 includes two adjacent power supply lines 123.

It will be noted that, two power supply lines 123 in a power supply line group 1230 may be arranged separately from each other; or two power supply lines 123 in a power supply line group 1230 may be integrally provided, that is, the two power supply lines 123 in the power supply line group 1230 are connected to each other and merged into a single power supply line 123. In FIG. 6, the two power supply lines 123 in the power supply line group 1230 being arranged separately from each other is illustrated as an example.

In addition, in the same power supply line group 1230, the two power supply lines 123 may be substantially symmetrical about the first axis line M1; and two adjacent data lines 122 belonging to different data line groups 1220 may also be substantially symmetrical about the first axis line M1.

Here, referring to FIG. 6 and FIG. 7, two data lines 122 in a data line group 1220 are electrically connected to two adjacent pixel circuits 121 belonging to different pixel circuit group 1210, respectively. Two power supply lines 123 in a power supply line group 1230 are electrically connected to two pixel circuits 121 in a pixel circuit group 1210, respectively.

Here, as shown in FIG. 6, the plurality of data line groups 1220 and the plurality of power supply line groups 1230 are alternately arranged in a second direction Y. That is to say, two power supply lines 123 in a power supply line group 1230 are concentratedly distributed, and two data lines 122 in a data line group 1220 are concentratedly distributed.

It will be noted that the second direction Y is perpendicular to the first direction X, and the second direction Y is a row direction in which the plurality of pixel circuits 121 are arranged.

On this basis, as shown in FIG. 6 and FIG. 7, there is no pixel circuit 121 between two data lines 122 in a data line group 1220. The light-transmissive zone S may be located between two data lines 122 in a same data line group 1220, for example. Moreover, the two data lines 122 in the data line group 1220 may have a large distance therebetween, and the area of the light-transmissive zone S may be designed to be large, so that the area of the light-irradiating opening 131 arranged in the light-transmissive zone S may be increased, and then the integrated transmittance of the light-irradiating region A2 may be increased, and the photosensitivity of the photosensitive device 500 may be improved.

In addition, as shown in FIG. 5 and FIG. 6, the light-irradiating opening 131 is substantially parallel to opposite edges of orthographic projections of first set line segments of the two data lines 122 in the same data line group 1220 on the substrate 110 (refer to FIG. 4), that is, the light-irradiating opening 131 is substantially parallel to a boundary of the light-transmissive zone S defined by the two data lines 122.

It will be noted that the first set line segments are portions of the two data lines 122 in the same data line group 1220 that correspond to the boundary of the light-transmissive zone S defined by the two data lines 122, reference may be made to the description below.

In this case, a distance between the light-irradiating opening 131 and opposite edges of the two data lines 122 may be set to a process limit value, so as to effectively prevent the driving circuit layer 120 from leaking light, and increase the ratio of the light-irradiating opening 131 to the light-transmissive zone S, thereby increasing the area of the light-irradiating opening 131 and increasing the integrated transmittance of the light-irradiating region A2.

In some embodiments, referring to FIG. 8, the data line 122 includes first straight line segments 1221 and first bent segments 1222 that are alternately connected. In the same data line group 1220, first bent segments 1222 of the two data lines 122 are bent toward directions away from each other.

For example, as shown in FIG. 8, the first bent segment 1222 includes a first data trace segment 1223, a second data trace segment 1224, and a third data trace segment 1225 that are connected in sequence.

Among them, the first data trace segment 1223 and the third data trace segment 1225 are respectively connected to first straight line segments 1221 on both sides of the first bent segment 1222, an extending direction of the second data trace segment 1224 is substantially same as an extending direction of the first straight line segments 1221, and the second data trace segment 1224 is farther away from first bent segments 1222 of the other data line 122 in the same data line group 1220 than the first straight line segments 1221.

On this basis, the first set line segment includes at least a portion of the first bent segment 1222. For example, the first set line segment includes a portion of the second data trace segment 1224, and includes a portion of the first data trace segment 1223 or a portion of the third data trace segment 1225.

Here, the portion of the first data trace segment 1223 is a portion of the first data trace segment 1223 located between a first scanning signal line 124 and a second scanning signal line 125 mentioned below; the portion of the second data trace segment 1224 is a portion of the second data trace segment 1224 located between the first scanning signal line 124 and the second scanning signal line 125 mentioned below; and the portion of the third data trace segment 1225 is a portion of the third data trace segment 1225 located between the first scanning signal line 124 and the second scanning signal line 125 mentioned below.

It will be noted that one of the first data trace segment 1223 and the third data trace segment 1225 is provided with an overlapping portion 1226 and is electrically connected to the pixel circuit 121 through the overlapping portion 1226. The first set line segment includes a data trace segment without the overlapping portion 1226. In FIG. 5 and FIG. 8, the first data trace segment 1223 is provided with the overlapping portion 1226 as an example for illustration. In this case, the first set line segment includes the portion of the second data trace segment 1224 and the portion of the third data trace segment 1225.

From the above, it can be seen that the first bent segments 1222 of the two data lines 122 in the data line group 1220 are bent toward directions away from each other, forming an avoidance, so that the area of the light-transmissive zone S may be designed larger, and the area of the light-irradiating opening 131 may be increased, thereby increasing the integrated transmittance of the light-irradiating region A2.

In some embodiments, referring to FIG. 5 and FIG. 7, the driving circuit layer 120 further includes first scanning signal lines 124, second scanning signal lines 125, enabling signal lines 126, first initialization signal lines 127, second initialization signal line 128 and reset signal lines 129.

It will be noted that, the first initialization signal line 127 can, for example, reset an anode of a light-emitting device 20 (refer to FIG. 4); the second initialization signal line 128 can, for example, reset a control electrode of a driving transistor.

Referring to FIG. 7, the first scanning signal line 124, the second scanning signal line 125, the enabling signal line 126, the first initialization signal line 127, the second initialization signal line 128 and the reset signal line 129 all extend substantially along the second direction Y.

Here, as shown in FIG. 7, the first scanning signal line 124, the second scanning signal line 125, the enabling signal line 126, the first initialization signal line 127, the second initialization signal line 128 and the reset signal line 129 are arranged circularly in the first direction X.

On this basis, as shown in FIG. 5 and FIG. 6, the light-transmitting region S may be located, for example, between adjacent first scanning signal lines 124 and second scanning signal lines 125.

It can be understood that, among signal lines arranged in the first direction X, a distance between the first scanning signal line 124 and the second scanning signal line 125 that are adjacent is relatively large, and there is no other conductive structure (such as the anode 21 of the light-emitting device 20 or a plate electrode of a capacitor). Therefore, by arranging the light-transmissive zone S between the first scanning signal line 124 and the second scanning signal line 125, the area of the light-transmissive zone S may be designed larger, so that the area of the light-irradiating opening 131 disposed in the light-transmissive zone S may be increased, thereby increasing the integrated transmittance of the light-irradiating region A2 and improving the photosensitivity of the photosensitive device 500.

In addition, as shown in FIG. 5, the light-irradiating opening 131 is substantially parallel to opposite edges of an orthographic projection of a second set line segment of the first scanning signal line 124 on the substrate 110, and substantially parallel to opposite edges of an orthographic projection of a third set line segment of the second scanning signal line 125 on the substrate 110.

Based on the above, as shown in FIG. 5 and FIG. 6, a single light-transmissive zone S may be enclosed by, for example, two adjacent data lines 122 in a data line group 1220, and a first scanning signal line 124 and a second scanning signal line 125 that are adjacent to the data line group 1220.

In this case, the first set line segment is a portion of the data line 122 located between the adjacent first scanning signal line 124 and second scanning signal line 125; the second set line segment is a portion of the first scanning signal line 124 located between two data lines 122 in a same data line group 1220; and the third set line segment is a portion of the second scanning signal line 125 located between the two data lines 122 in the same data line group 1220.

In this case, the distance between the light-irradiating opening 131 and the boundary of the light-transmissive zone S defined by the first scanning signal line 124 and the second scanning signal line 125 may be set to a process limit value, so as to improve the ratio of the light-irradiating opening 131 to the light-transmissive zone S, thereby increasing the area of the light-irradiating opening 131 and improving the integrated transmittance of the light-irradiating region A2.

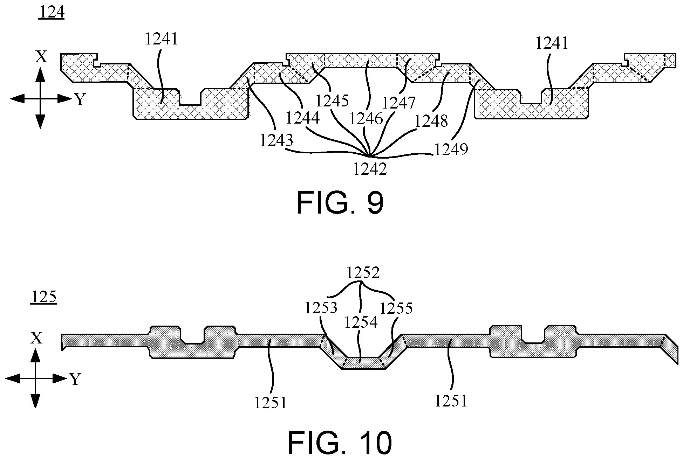

In some embodiments, referring to FIG. 9, the first scanning signal line 124 includes second straight line segments 1241 and second bent segments 1242 that are alternately connected; referring to FIG. 10, the second scanning signal line 125 includes third straight line segments 1251 and third bent segments 1252 that are alternately connected. A second bent segment 1242 and a third bent segment 1252 that are adjacent are bent toward directions away from each other.

For example, as shown in FIG. 9, the second bent segment 1242 includes a first reset trace segment 1243, a second reset trace segment 1244, a third reset trace segment 1245, a fourth reset trace segment 1246, a fifth reset trace segment 1247, a sixth reset trace segment 1248, and a seventh reset trace segment 1249 that are connected in sequence.

Here, the first reset trace segment 1243 and the seventh reset trace segment 1249 are respectively connected to second straight line segments 1241 on both sides of the second bent segment 1242. An extending direction of the second reset trace segment 1244, the fourth reset trace segment 1246 and the sixth reset trace segment 1248 is substantially same as an extending direction of the second straight line segments 1241, and the second reset trace segment 1244 and the sixth reset trace segment 1248 are farther away from the second scanning signal line 125 than the second straight line segments 1241. The fourth reset trace segment 1246 is farther away from the adjacent second scanning signal line 125 than the second reset trace segment 1244 and the sixth reset trace segment 1248.

On this basis, referring to FIG. 6 and FIG. 9, the second set line segment includes at least a portion of the second bent segment 1242. For example, the second set line segment includes the fourth reset trace segment 1246, a portion of the third reset trace segment 1245, and a portion of the fifth reset trace segment 1247.

Here, the portion of the third reset trace segment 1245 is a portion of the third reset trace segment 1245 located between two data lines 122 in a same data line group 1220; and the portion of the fifth reset trace segment 1247 is a portion of the fifth reset trace segment 1247 located between the two data lines 122 in the same data line group 1220.

It will be noted that the second set line segment may further include the second straight line segment 1241, which is not limited in embodiments of the present disclosure.

For example, as shown in FIG. 10, the third bent segment 1252 includes a first scanning trace segment 1253, a second scanning trace segment 1254, and a third scanning trace segment 1255.

Here, the first scanning trace segment 1253 and the third scanning trace segment 1255 are respectively connected to third straight line segments 1251 on both sides of the third bent segment 1252, and an extending direction of the second scanning trace segment 1254 is substantially same as an extending direction of the third straight line segments 1251, and the second scanning trace segment 1254 is farther away from the adjacent first scanning signal line 124 than the third straight line segments 1251.

On this basis, referring to FIG. 6 and FIG. 10, the third set line segment includes the third bent segment 1252 and a portion of the third straight line segment 1251. For example, the third set line segment includes the first scanning trace segment 1253, the second scanning trace segment 1254 and the third scanning trace segment 1255, and a portion of the third straight line segment 1251 located between two data lines 122 in a same data line group 1220.

From the above, it can be seen that the second bent segment 1242 of the first scanning signal line 124 and the third bent segment 1252 of the second scanning signal line 125 that are adjacent are bent toward directions away from each other to form an avoidance, so that the area of the light-transmissive zone S may be designed larger, and the area of the light-irradiating opening 131 may be increased, thereby increasing the integrated transmittance of the light-irradiating region A2.

It should be understood that, as shown in FIG. 4 and FIG. 7, the driving circuit layer 120 further includes first semiconductor patterns 30, transfer lines 40 and second semiconductor patterns 50.

On this basis, for example, the first scanning signal line 124 may overlap with a first semiconductor pattern 30 to form a P-type transistor. For example, the second scanning signal line 125 may overlap with a second semiconductor pattern 50 to form an N-type transistor. The enabling signal line 126, the first initialization signal line 127, the second initialization signal line 128 and the reset signal line 129 may respectively overlap with first semiconductor patterns 30 to form a plurality of thin film transistors 10.

In addition, the plurality of thin film transistors 10 of the plurality of pixel circuits 121 may be electrically connected through the transfer lines 40 and conductive portions in the first semiconductor pattern 30 and/or the second semiconductor pattern 50.

As shown in FIG. 4, the thin film transistor 10 includes a semiconductor channel 11, a source 12, a drain 13 and a gate 14, and the source 12 and the drain 13 are respectively in contact with the semiconductor channel 11.

It will be noted that the source 12 and the drain 13 may be interchanged, that is, the reference character "12" in FIG. 4 represents the drain, and the reference character "13" in FIG. 4 represents the source.

On this basis, as shown in FIG. 5, FIG. 6 and FIG. 7, for example, a single light-transmissive zone S may also be enclosed by a portion of the first semiconductor pattern 30 located between two adjacent data lines 122 in a data line group 1220, and a first scanning signal line 124 and a second scanning signal line 125 that are adjacent to the portion of the first semiconductor pattern 30.

In this case, the second set line segment is a portion of the first scanning signal line 124 located between first semiconductor patterns 30 between the two data lines 122 in the same data line group 1220; and the third set line segment is a portion of the second scanning signal line 125 located between first semiconductor patterns 30 between the two data lines 122 in the same data line group 1220.

The driving circuit layer 120 mentioned above will be exemplarily introduced below in combination with the film layer structure of the display panel 100.

For example, as shown in FIG. 4, along a direction perpendicular to the substrate 110 and away from the substrate 110, the display panel 100 includes a first semiconductor layer ACT, a first gate conductive layer GT1, a second gate conductive layer GT2, a second semiconductor layer ACT2, a third gate conductive layer GT3, a first source-drain conductive layer SD1 and a second source-drain conductive layer SD2 sequentially.

It should be understood that referring to FIG. 4, among the first semiconductor layer ACT1, the first gate conductive layer GT1, the second gate conductive layer GT2, the second semiconductor layer ACT2, the third gate conductive layer GT3, the first source-drain conductive layer SD1, and the second source-drain conductive layer SD2, every two adjacent layers is provided therebetween with an insulating film layer, for example, a first gate insulating layer GI1, a first interlayer insulating layer ILD1, a second gate insulating layer GI2, a third gate insulating layer GI3, a second interlayer insulating layer ILD2, a first planarization layer PLN1 and the second planarization layer PLN2, which are not specifically limited in embodiments of the present disclosure.

Here, the first semiconductor patterns 30 may be located in the first semiconductor layer ACT1. The first scanning signal lines 124 and the enabling signal lines 126 may be located in the first gate conductive layer GT1. The second initialization signal lines 128 may be located in the second gate conductive layer GT2. The enabling signal lines 126 and the first initialization signal lines 127 may be located in the third gate conductive layer GT3. The second scanning signal line 125 may include two scanning signal sub-lines, one scanning signal sub-line may be located in the second gate conductive layer GT2, and the other scanning signal sub-line may be located in the third gate conductive layer GT3. The reset signal line 129 may include two reset signal sub-lines, one reset signal sub-line may be located in the second gate conductive layer GT2, and the other reset signal sub-line may be located in the third gate conductive layer GT3.

In some embodiments, as shown in FIG. 4, FIG. 5 and FIG. 11A, the pixel defining layer 130 is further provided therein with a plurality of pixel openings 132, and the plurality of pixel openings 132 include a plurality of first pixel openings 1321, a plurality of second pixel openings 1322, a plurality of third pixel openings 1323 and a plurality of fourth pixel openings 1324.

Here, referring to FIG. 4, a light-emitting device 20 is disposed in a pixel opening 132. The light-emitting device 20 includes an anode 21, a light-emitting functional layer 22 and a cathode 23. The anode 21 is electrically connected to a source 12 or drain 13 of a thin film transistor 10 of the plurality of thin film transistors 10. FIG. 4 illustrates an example in which the anode 21 is electrically connected to the drain 13 of the thin film transistor 10.

It will be noted that the light-emitting functional layer 22 may include only a light-emitting layer; or in addition to the light-emitting layer, the light-emitting functional layer 22 further includes at least one of an electron transport layer (ETL), an electron injection layer (ElL), a hole transport layer (HTL) and a hole injection layer (HIL).

Here, as shown in FIG. 5, FIG. 6 and FIG. 7, in a same pixel circuit group 1210, two pixel circuits 121 are substantially symmetrical about the first axis line M1, and the anode 21 of the light-emitting device 20 may also be substantially symmetrical about the first axis line M1, for example, so that thicknesses of two sides of the anode 21 in the second direction Y may be balanced, and the flatness of the anode 21 may be improved.

It will be noted that the shape of the anode 21 may be polygonal, circular or irregular. For example, the shape of the anode 21 may be any one of a rhombus, a regular hexagon, a regular octagon, a regular dodecagon and a circle.

Moreover, as shown in FIG. 5, FIG. 6 and FIG. 7, in a same power supply line group 1230, the two power supply lines 123 may be substantially symmetrical about the first axis line M1, and the anode 21 of the light-emitting device 20 may also substantially symmetrical be about the first axis line M1. In this way, edges of the anode 21 on two sides opposite in the second direction Y may be supported by the power supply lines 123, the thickness consistency of the anode 21 on the two sides in the second direction Y is good, and the flatness of the anode 21 is good.

In addition, two adjacent data lines 122 belonging to different data line groups 1220 may also be substantially symmetrical to the first axis line M1. In this way, if edges on two sides of the anode 21 opposite in the second direction Y overlap with the two data lines 122, they can be supported by the data lines 122, the thickness consistency of the anode 21 on the two sides in the second direction Y is good, and the flatness of the anode 21 is good.

It should be understood that referring to FIG. 2 and FIG. 4, the display region A of the display panel 100 is provided therein with a plurality of sub-pixels P, and each sub-pixel P includes a pixel circuit 121 and a light-emitting device 20.

Colors of light emitted by the plurality of sub-pixels P include a plurality of colors. For example, colors of the light emitted by the plurality of sub-pixels P include a first color, a second color, and a third color.

It will be noted that the first color, the second color and the third color are three primary colors. For example, the first color is red, the second color is blue, and the third color is green.

In the following, embodiments of the present disclosure will be described by taking an example in which the first color is red, the second color is blue, and the third color is green, and a sub-pixel P that emits light of red is called a red sub-pixel, a sub-pixel P that emits light of blue is called a blue sub-pixel and a sub-pixel P that emits light of green is called a green sub-pixel.

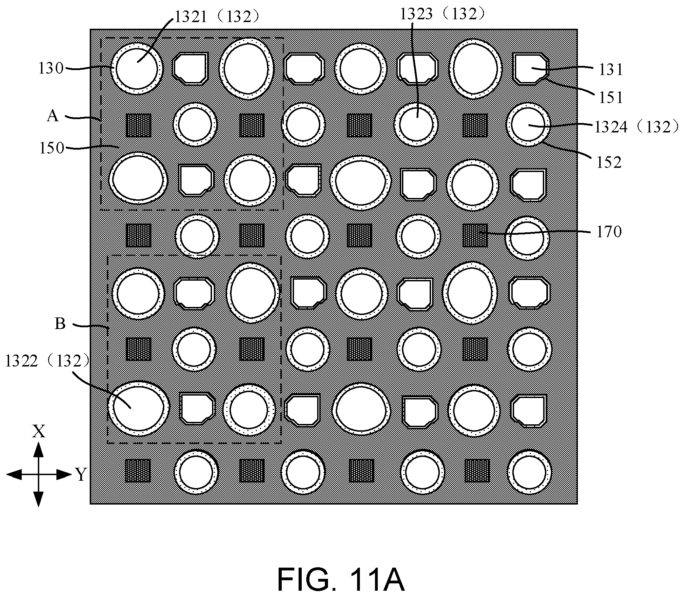

On this basis, referring to FIG. 4 and FIG. 11A, for example, the first pixel opening 1321 may be provided with a light-emitting device 20 of a red sub-pixel, the second pixel opening 1322 may be provided with a light-emitting device 20 of a blue sub-pixel, the third pixel opening 1323 may be provided with a light-emitting device 20 of a green sub-pixel, and the fourth pixel opening 1324 may be provided with a light-emitting device 20 of another green sub-pixel.

Because sensitivities of human eyes to red light, green light and blue light are different, that is, the sensitivity of the human eyes to green light is greater than the sensitivity to red light, and the sensitivity to red light is greater than the sensitivity to blue light; therefore, the area of the first pixel opening 1321 is less than the area of the second pixel opening 1322 and greater than the area of the third pixel opening 1323. The area of the third pixel opening 1323 is substantially the same as the area of the fourth pixel opening 1324.

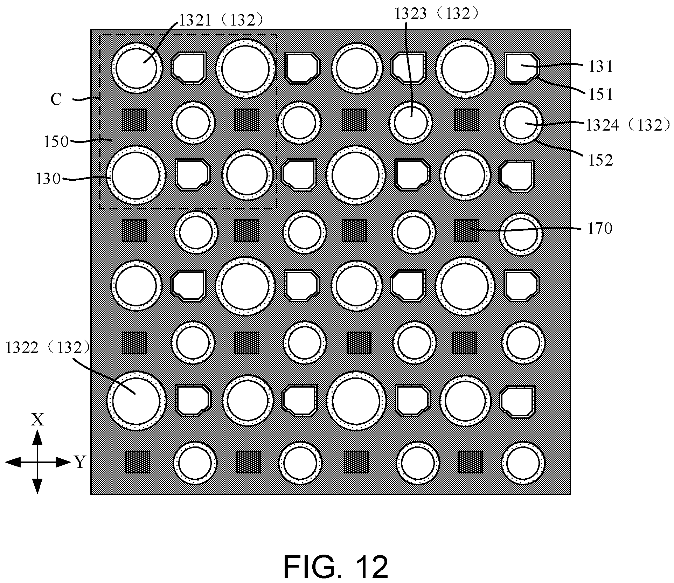

On this basis, as shown in FIG. 11A and FIG. 12, the plurality of first pixel openings 1321 and the plurality of second pixel openings 1322 are arranged in an array in multiple rows and multiple columns, each row includes multiple first pixel openings 1321 and multiple second pixel openings 1322 that are arranged alternately along the second direction Y, and each column includes multiple first pixel openings 1321 and multiple second pixel openings 1322 that are arranged alternately along the first direction X.

The plurality of third pixel openings 1323 and the plurality of fourth pixel openings 1324 are arranged in an array in multiple rows and multiple columns, each row includes multiple third pixel openings 1323 and multiple fourth pixel openings 1324 that are arranged alternately along the second direction Y, and each column includes multiple third pixel openings 1323 and multiple fourth pixel openings 1324 that are arranged alternately along the first direction X. Here a third pixel opening 1323 is located between first pixel openings 1321 and second pixel openings 1322 that are arranged in two rows and two columns, and a fourth pixel opening 1324 adjacent to the third pixel opening 1323 is located between first pixel openings 1321 and second pixel openings 1322 that are arranged in another two rows and two columns.

In this arrangement, the display effect of the display panel 100 may be effectively improved, the display fineness may be improved, and an edge jaggy feeling and a display grainy feeling may be reduced.

On this basis, as shown in FIG. 11A and FIG. 12, the light-irradiating opening 131 is located between a first pixel opening 1321 and a second pixel opening 1322 adjacent in the second direction Y.

In some embodiments, as shown in FIG. 12, an orthogonal projection, on the substrate 110, of each of the first pixel opening 1321, the second pixel opening 1322, the third pixel opening 1323, and the fourth pixel opening 1324 is substantially circular.

On this basis, since the area of the second pixel opening 1322 is greater than that of the first pixel opening 1321, in order to make the minimum distance between the light-irradiating opening 131 and the second pixel opening 1322 meet the process requirements, in some examples, a distance between a side of the light-irradiating opening 131 proximate to the second pixel opening 1322 and the light-transmissive zone S is increased, resulting in a difference in shape between an edge of the light-irradiating opening 131 proximate to the second pixel opening 1322 and an edge of the light-transmissive zone S proximate the second pixel opening 1322.

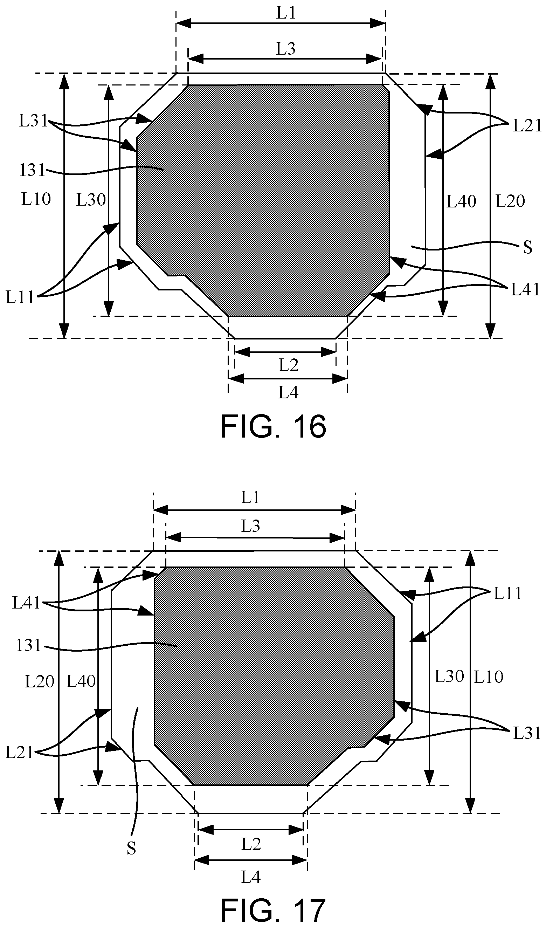

For example, referring to FIG. 16, FIG. 17 and FIG. 18, the light-transmissive zone S includes a first folded edge L10, a first straight edge L1, a second folded edge L20, and a second straight edge L2 that are connected in sequence; and the light-irradiating opening 131 includes a third folded edge L30, a third straight edge L3, a fourth folded edge L40, and a fourth straight edge L4 that are connected in sequence.

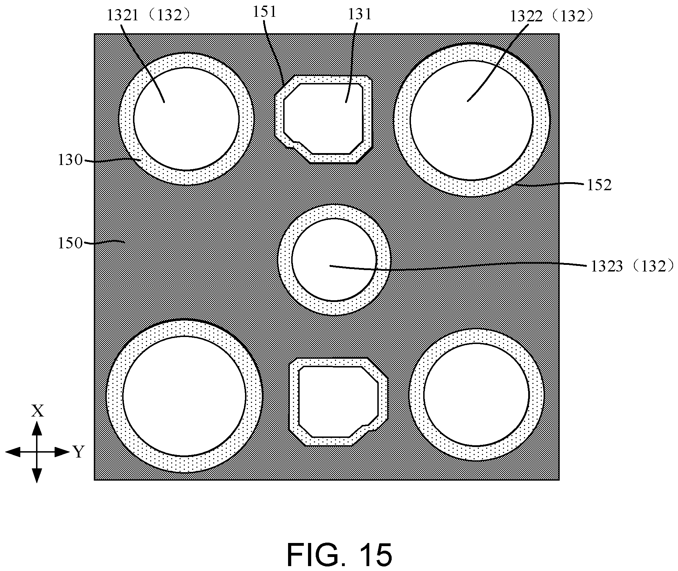

As shown in FIG. 15, FIG. 16, and FIG. 17, the first folded edge L10 includes a plurality of first straight sub-edges L11 connected in sequence, and the second folded edge L20 includes a plurality of second straight sub-edges L21 connected in sequence; and the first straight edge L1 and the second straight edge L2 are an edge closest to a third pixel opening 1323 adjacent to the light-transmissive zone S and an edge closest to a fourth pixel opening 1324 adjacent to the light-transmissive zone S, respectively.

As shown in FIG. 15, FIG. 16, and FIG. 17, the third folded edge L30 is proximate to the first pixel opening 1321 and includes a plurality of third straight sub-edges L31 connected in sequence; and the fourth folded edge L40 is proximate to the second pixel opening 1322 and includes a plurality of fourth straight sub-edges L41 connected in sequence.

Here, the third straight edge L3 is substantially parallel to the first straight edge L2, and the fourth straight edge L4 is substantially parallel to the second straight edge L2. The plurality of third straight sub-edges L31 in the third folded edge L30 are in one-to-one correspondence with and substantially parallel to the plurality of first straight sub-edges L11 in the first folded edge L10. The number of the plurality of fourth straight sub-edges L41 in the fourth folded edge L40 is less than the number of the plurality of second straight sub-edges L21 in the second folded edge L20, and each fourth straight sub-edge L41 is substantially parallel to a second straight sub-edge L21.

In this arrangement, a distance between the third folded edge L30 of the light-irradiating opening 131 and the first folded edge L10 of the light-transmissive zone S, a distance between the third straight edge L3 of the light-irradiating opening 131 and the first straight edge L1 of the light-transmissive zone S, and a distance between the fourth straight edge L4 of the light-irradiating opening 131 and the second straight edge L2 of the light-transmissive zone S may all be set to a process limit value to increase the ratio of the light-irradiating opening 131 to the light-transmissive zone S, thereby increasing the area of the light-irradiating opening 131 and improving the integrated transmittance of the light-irradiating region A2.

Moreover, for example, the fourth folded edge L40 of the light-irradiating opening 131, with respect to the light-transmissive zone S, may be without a straight sub-edge that extends substantially along the second direction Y, so that the minimum distance between the fourth folded edge L40 of the light-irradiating opening 131 and the second pixel opening 1322 is greater than or equal to a process limit value that allows the light-irradiating opening 131 to be separated from the second pixel opening 1322.

Based on the above, in a case that the orthogonal projection, on the substrate 110, of each of the first pixel opening 1321, the second pixel opening 1322, the third pixel opening 1323, and the fourth pixel opening 1324 is substantially circular, the aperture ratio of the light-irradiating opening 131 in the light-irradiating region A2 may reach 4.6%, and its integrated transmittance is 1.1%.

In some other embodiments, as shown in FIG. 11A, an orthogonal projection, on the substrate 110, of each of the first pixel opening 1321, the third pixel opening 1323, and the fourth pixel opening 1324 is substantially circular.

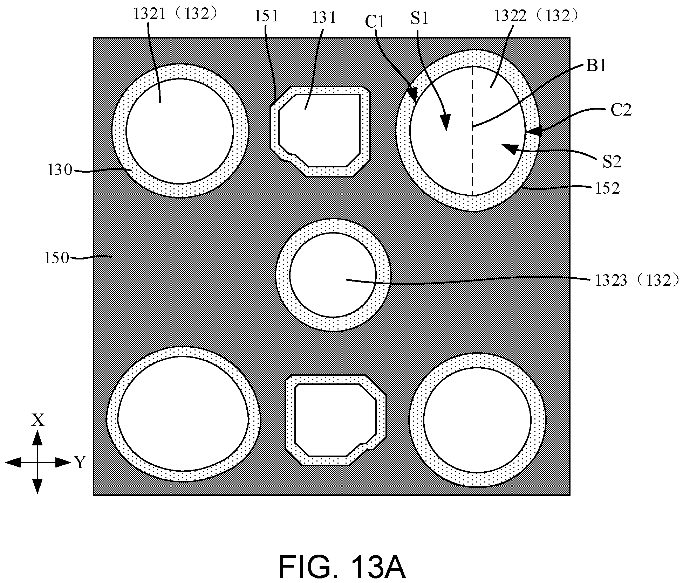

Referring to FIG. 11A and FIG. 13A, an outer contour of the second pixel opening 1322 includes a first curved edge C1 and a second curved edge C2, both ends of the first curved edge C1 are respectively connected to both ends of the second curved edge C2, and two connection points of the first curved edge C1 and the second curved edge C2 are a first connection point and a second connection point.

Continue to refer to FIG. 11A and FIG. 13A, a connection line between the first connection point and the second connection point is a first line segment B1; a length of the first line segment B1 is a maximum dimension of the second pixel opening 1322, and divides the second pixel opening 1322 into a first sub-portion S1 including the first curved edge C1 and a second sub-portion S2 including the second curved edge C2; an area of the first sub-portion S1 is greater than an area of the second sub-portion S2.

On this basis, since the area of the second pixel opening 1322 is greater than that of the first pixel opening 1321, in order to make the minimum distance between the light-irradiating opening 131 and the second pixel opening 1322 meet the process requirements, in some examples, a distance between a side of the light-irradiating opening 131 proximate to the second pixel opening 1322 and the light-transmissive zone S is increased, resulting in a difference in shape between an edge of the light-irradiating opening 131 proximate to the second pixel opening 1322 and an edge of the light-transmissive zone S proximate the second pixel opening 1322.

For example, referring to FIG. 16, FIG. 17 and FIG. 18, the light-transmissive zone S includes a first folded edge L10, a first straight edge L1, a second folded edge L20, and a second straight edge L2 that are connected in sequence; and the light-irradiating opening 131 includes a third folded edge L30, a third straight edge L3, a fourth folded edge L40, and a fourth straight edge L4 that are connected in sequence.

As shown in FIG. 16, the first folded edge L10 includes a plurality of first straight sub-edges L11 connected in sequence, and the second folded edge L20 includes a plurality of second straight sub-edges L21 connected in sequence; and the first straight edge L1 and the second straight edge L2 are an edge closest to a third pixel opening 1323 adjacent to the light-transmissive zone S and an edge closest to a fourth pixel opening 1324 adjacent to the light-transmissive zone S, respectively.

As shown in FIG. 16, the third folded edge L30 is proximate to the first pixel opening 1321 and includes a plurality of third straight sub-edges L31 connected in sequence; and the fourth folded edge L40 is proximate to the second pixel opening 1322 and includes a plurality of fourth straight sub-edges L41 connected in sequence.

Here, the third straight edge L3 is substantially parallel to the first straight edge L2, and the fourth straight edge L4 is substantially parallel to the second straight edge L2. The plurality of third straight sub-edges L31 in the third folded edge L30 are in one-to-one correspondence with and substantially parallel to the plurality of first straight sub-edges L11 in the first folded edge L10. Each fourth straight sub-edge L41 is substantially parallel to a second straight sub-edge L21.

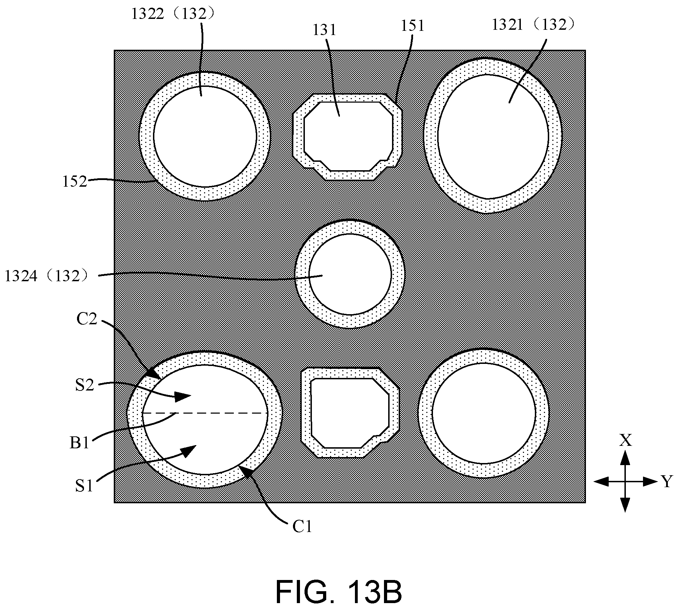

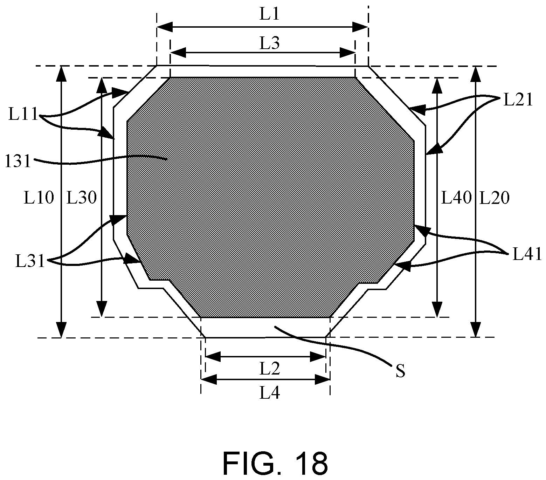

Here, as shown in FIG. 13B and FIG. 18, in a case where the fourth folded edge L40 is opposite to the second curved edge C2 of the second pixel opening 1322, the plurality of fourth straight sub-edges L41 in the fourth folded edge L40 are in one-to-one correspondence with the plurality of second straight sub-edges L21 in the second folded edge L20; and as shown in FIG. 13A, FIG. 16 and FIG. 17, in a case where the fourth folded edge L40 is non-opposite to the second curved edge C2 of the second pixel opening 1322, the number of the plurality of fourth straight sub-edges L41 in the fourth folded edge L40 is less than the number of the plurality of second straight sub-edges L21 in the second folded edge L20.

It will be noted that there be two cases in which the fourth folded edge L40 is non-opposite to the second curved edge C2 of the second pixel opening 1322, in one case, the fourth folded edge L40 (refer to FIG. 16) is opposite to the first curved edge C1 in FIG. 13A, in the other case, the fourth folded edge L40 (refer to FIG. 17) is opposite to the first connection point or second connection point in FIG. 13A.

In this arrangement, a distance between the third folded edge L30 of the light-irradiating opening 131 and the first folded edge L10 of the light-transmissive zone S, a distance between the third straight edge L3 of the light-irradiating opening 131 and the first straight edge L1 of the light-transmissive zone S, and a distance between the fourth straight edge L4 of the light-irradiating opening 131 and the second straight edge L2 of the light-transmissive zone S may all be set to a process limit value to increase the ratio of the light-irradiating opening 131 to the light-transmissive zone S, thereby increasing the area of the light-irradiating opening 131 and improving the integrated transmittance of the light-irradiating region A2.

Moreover, in the case where the fourth folded edge L40 is opposite to the second curved edge C2 of the second pixel opening 1322, a distance between the fourth folded edge L40 of the light-irradiating opening 131 and the fourth folded edge L40 of the light-transmissive zone S may be set to a process limit value to increase the ratio of the light-irradiating opening 131 to the light-transmissive zone S, thereby increasing the area of the light-irradiating opening 131 and improving the integrated transmittance of the light-irradiating region A2.

In the case where the fourth folded edge L40 is non-opposite to the second curved edge C2 of the second pixel opening 1322, the fourth folded edge L40 of the light-irradiating opening 131, with respect to the light-transmissive zone S, may be without a straight sub-edge that extends substantially along the second direction Y, so that the minimum distance between the fourth folded edge L40 of the light-irradiating opening 131 and the second pixel opening 1322 is greater than or equal to a process limit value that allows the light-irradiating opening 131 to be separated from the second pixel opening 1322.

Based on the above, in a case that the orthogonal projection, on the substrate 110, of each of the first pixel opening 1321, the third pixel opening 1323, and the fourth pixel opening 1324 is substantially circular, and the outer contour of the second pixel opening 1322 includes the first curved edge C1 and the second curved edge C2, the aperture ratio of the light-irradiating opening 131 in the light-irradiating region A2 may reach 5.1 %, and its integrated transmittance is 1.23%.

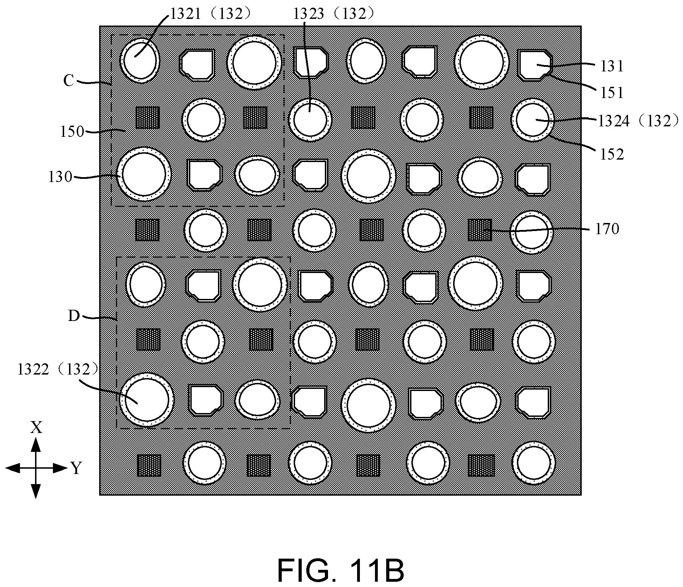

In yet some other embodiments, as shown in FIG. 11B, an orthogonal projection, on the substrate 110, of each of the second pixel opening 1322, the third pixel opening 1323, and the fourth pixel opening 1324 is substantially circular.

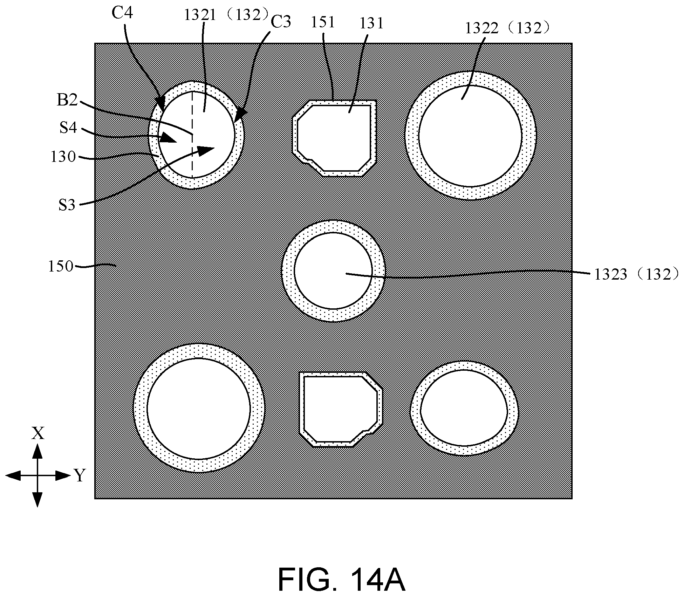

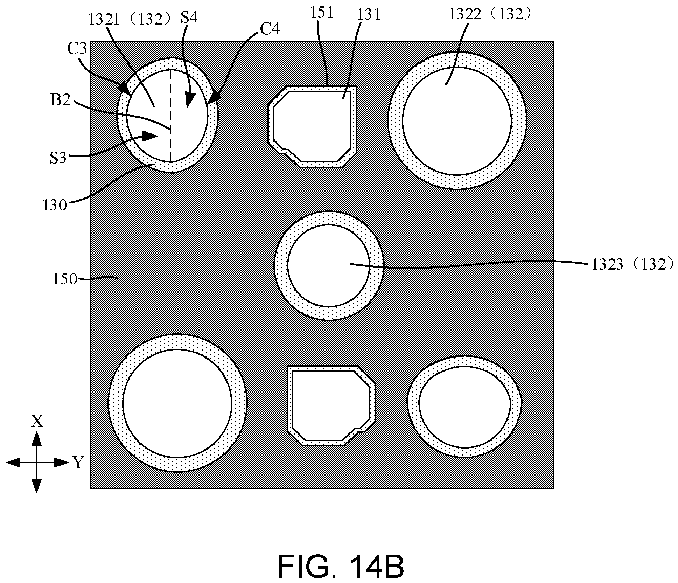

Here, referring to FIG. 11B and FIG. 14A, an outer contour of the first pixel opening 1321 includes a third curved edge C3 and a fourth curved edge C4, both ends of the third curved edge C3 are respectively connected to both ends of the fourth curved edge C4, and two connection points of the third curved edge C3 and the fourth curved edge C4 are a third connection point and a fourth connection point.

Continue to refer to FIG. 11B and FIG. 14A, a connection line between the third connection point and the fourth connection point is a second line segment B2; a length of the second line segment B2 is a maximum dimension of the first pixel opening 1321, and divides the first pixel opening 1321 into a third sub-portion S3 including the third curved edge C3 and a fourth sub-portion S4 including the fourth curved edge C4; an area of the third sub-portion S3 is greater than an area of the fourth sub-portion S4.

In this case, compared with embodiments in which the outer contour of the second pixel opening 1322 includes the first curved edge C1 and the second curved edge C2, the aperture ratio of the pixel opening 132 in embodiments is relatively large in which the outer contour of the first pixel opening 1321 includes the third curved edge C3 and the fourth curved edge C4.

On this basis, since the area of the second pixel opening 1322 is greater than that of the first pixel opening 1321, in order to make the minimum distance between the light-irradiating opening 131 and the second pixel opening 1322 meet the process requirements, in some examples, a distance between a side of the light-irradiating opening 131 proximate to the second pixel opening 1322 and the light-transmissive zone S is increased, resulting in a difference in shape between an edge of the light-irradiating opening 131 proximate to the second pixel opening 1322 and an edge of the light-transmissive zone S proximate the second pixel opening 1322.

For example, referring to FIG. 16, FIG. 17 and FIG. 18, the light-transmissive zone S includes a first folded edge L10, a first straight edge L1, a second folded edge L20, and a second straight edge L2 that are connected in sequence; and the light-irradiating opening 131 includes a third folded edge L30, a third straight edge L3, a fourth folded edge L40, and a fourth straight edge L4 that are connected in sequence.

As shown in FIG. 15, FIG. 16 and FIG. 17, the first folded edge L10 includes a plurality of first straight sub-edges L11 connected in sequence, and the second folded edge L20 includes a plurality of second straight sub-edges L21 connected in sequence; and the first straight edge L1 and the second straight edge L2 are an edge closest to a third pixel opening 1323 adjacent to the light-transmissive zone S and an edge closest to a fourth pixel opening 1324 adjacent to the light-transmissive zone S, respectively.

As shown in FIG. 15, FIG. 16, and FIG. 17, the third folded edge L30 is proximate to the first pixel opening 1321 and includes a plurality of third straight sub-edges L31 connected in sequence; and the fourth folded edge L40 is proximate to the second pixel opening 1322 and includes a plurality of fourth straight sub-edges L41 connected in sequence.

Here, referring to FIG. 16 and FIG. 17, the third straight edge L3 is substantially parallel to the first straight edge L2, and the fourth straight edge L4 is substantially parallel to the second straight edge L2. The plurality of third straight sub-edges L31 in the third folded edge L30 are in one-to-one correspondence with and substantially parallel to the plurality of first straight sub-edges L11 in the first folded edge L10.

Referring to FIG. 14A, FIG. 14B, FIG. 16 and FIG. 17, the number of the plurality of fourth straight sub-edges L41 in the fourth folded edge L40 is less than the number of the plurality of second straight sub-edges L21 in the second folded edge L20, and each fourth straight sub-edge L41 is substantially parallel to a second straight sub-edge L21.

In this arrangement, a distance between the third folded edge L30 of the light-irradiating opening 131 and the first folded edge L10 of the light-transmissive zone S, a distance between the third straight edge L3 of the light-irradiating opening 131 and the first straight edge L1 of the light-transmissive zone S, and a distance between the fourth straight edge L4 of the light-irradiating opening 131 and the second straight edge L2 of the light-transmissive zone S may all be set to a process limit value to increase the ratio of the light-irradiating opening 131 to the light-transmissive zone S, thereby increasing the area of the light-irradiating opening 131 and improving the integrated transmittance of the light-irradiating region A2.

Moreover, the fourth folded edge L40 of the light-irradiating opening 131, with respect to the light-transmissive zone S, may be without a straight sub-edge that extends substantially along the second direction Y, so that the minimum distance between the fourth folded edge L40 of the light-irradiating opening 131 and the second pixel opening 1322 is greater than or equal to a process limit value that allows the light-irradiating opening 131 to be separated from the second pixel opening 1322.

Based on the above, in a case that the orthogonal projection, on the substrate 110, of each of the second pixel opening 1322, the third pixel opening 1323, and the fourth pixel opening 1324 is substantially circular, and the outer contour of the first pixel opening 1321 includes the third curved edge C3 and the fourth curved edge C4, the aperture ratio of the light-irradiating opening 131 in the light-irradiating region A2 may reach 4.6%, and its integrated transmittance is 1.1%.

In some embodiments, referring to FIG. 4, the display panel 100 further includes an encapsulation layer 180, and the encapsulation layer 180 is arranged on a side of the pixel defining layer 130 away from the substrate 110 to reduce the risk of water and oxygen corrosion.

Here, the encapsulation layer 180 may be an encapsulation film or an encapsulation substrate.

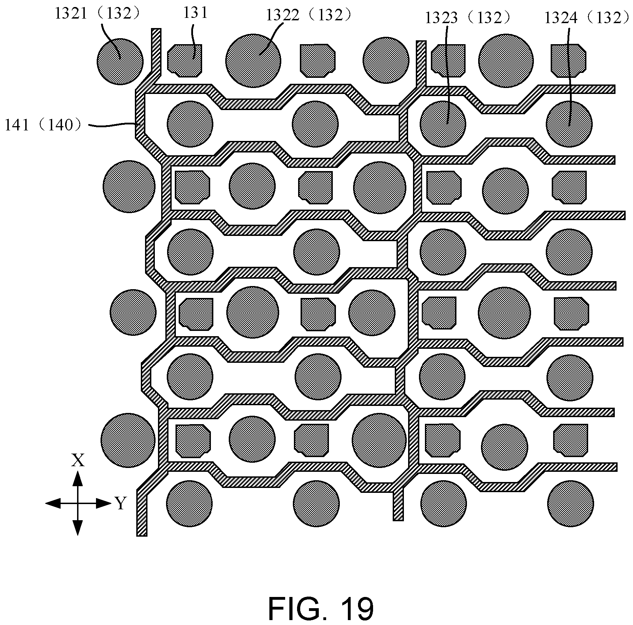

In some embodiments, referring to FIG. 4 and FIG. 19, the display panel 100 further includes a touch layer 140. The touch layer 140 is arranged on a side of the pixel defining layer 130 away from the substrate 110.

For example, referring to FIG. 4, the display panel 100 further includes the encapsulation layer 180, and the touch layer 140 arranged on a side of the encapsulation layer 180 away from the substrate 110.

As shown in FIG. 4 and FIG. 19, the touch layer 140 includes a plurality of touch lines 141, and an orthographic projection of the plurality of touch lines 141 on the substrate 110 is staggered from an orthogonal projection of the pixel openings 132 and the light-irradiating openings 131 on the substrate 110. The plurality of touch lines 141 are arranged crosswise to form a mesh structure.

Here, the plurality of touch lines 141 form a plurality of driving electrodes and sensing electrodes which are mutually insulated, and a capacitive node may be formed between a driving electrode and a sensing electrode. It will be noted that the driving electrodes and the sensing electrodes may be arranged in a same layer or in different layers, which is not specifically limited in embodiments of the present disclosure.

In this case, applying a pulsed or alternating voltage to the driving electrodes through a touch chip on the circuit board 400 (refer to FIG. 3) can generate induced charges on the sense electrodes, the amount of the induced charges is susceptible to external influences (e.g., touch or proximity of a finger). That is, when a finger touches or approaches a capacitive node, the capacitance at the capacitive node changes. The touch chip on the circuit board 400 (refer to FIG. 3), via the sensing electrodes, can measure the change in capacitance and, based on the measurement of the change in capacitances across the entire touch layer 140, determine a location of the touch or proximity of the finger.

Here, there exists at least such one row of light-irradiating openings 131 that there is no touch line 141 between this row of light-irradiating openings 131 and both first pixel openings 1321 and second pixel openings 1322 adjacent thereto in the second direction Y.

It can be understood that, in a case where there is no touch line 141 between a light-irradiating opening 131 and a pixel opening 132, there is no need to reserve a wiring space for the touch line 141 between the light-irradiating opening 131 and the pixel opening 132. A distance between the light-irradiating opening 131 and the pixel opening 132 may be set small, that is, the area of the light-irradiating opening 131 may be set large, so as to improve the integrated transmittance of the light-irradiating region A2.

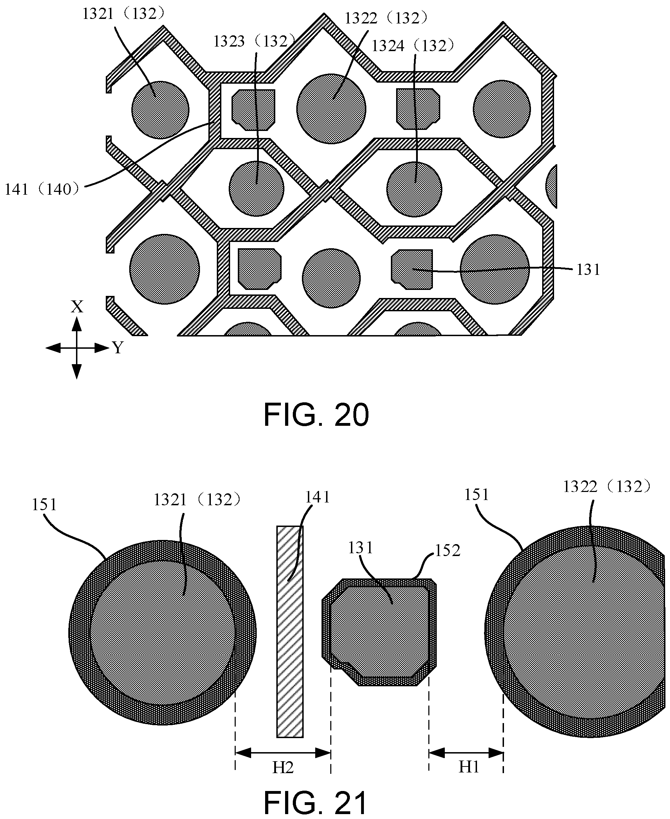

That is to say, referring to FIG. 21, in a case where there is no touch line 141 between a light-irradiating opening 131 and a pixel opening 132, a distance between the light-irradiating opening 131 and the pixel opening 132 is a first distance H1; and in a case where there is a touch line 141 between a light-irradiating opening 131 and a pixel opening 132, a distance between the light-irradiating opening 131 and the pixel opening 132 is a second distance H2. The first distance H1 is less than the second distance H2.

The first distance H1 may be in a range of 7 µm to 16 µm, inclusive. For example, the first distance H1 may be any one of 7 µm, 7.5 µm, 9 µm, 12 µm, 13 µm, 15.7 µm, and 16 µm.

The second distance H2 is in a range of 8 µm to 20 µm, inclusive. For example, the second distance H2 may be any one of 8 µm, 8.3 µm, 10 µm, 12 µm, 13 µm, 16 µm, 18.5 µm, and 20 µm.

For example, as shown in FIG. 19 and FIG. 20, first pixel openings 1321 and second pixel openings 1322 in a same row are divided into a plurality of pixel opening groups 1320, and each pixel opening group 1320 includes a first pixel opening 1321 and a second pixel opening 1322 that are adjacent.

Here, in a same pixel opening group 1320, a first pixel opening 1321 and a second pixel opening 1322 is provided therebetween with a touch line 141; and there is no touch line 141 between a first pixel opening 1321 and a second pixel opening 1322 that are adjacent and belong to different pixel opening groups 1320 in the second direction Y.

In this case, the plurality of touch lines 141 may be evenly distributed in the entire display region A, and there is no touch line 141 between each of half of the light-irradiating openings 131 and pixel openings 132 on two sides. The aperture ratio of the light-irradiating opening 131 is increased, and the integrated transmittance is increased.

In some embodiments, referring to FIG. 4, the display panel 100 further includes a black matrix 150, and the black matrix 150 is arranged on the side of the pixel defining layer 140 away from the substrate 110. Here, in a case where the display panel 100 includes the touch layer 140, the black matrix 150 is arranged on a side of the touch layer 140 away from the substrate 110.

It will be noted that the black matrix 150 is used to separate light emitted from different sub-pixels P, and has the function of reducing the reflected light after the external ambient light enters the display panel 100.

As shown in FIG. 11A, the black matrix 150 is provided therein with a plurality of first avoidance openings 151 and a plurality of second avoidance openings 152.

It will be noted that a distance between a first avoidance opening 151 and a second avoidance opening 152 is greater than or equal to a first preset value, and the first preset value is a process limit value allowing the first avoidance opening 151 to be separated from the second avoidance opening 152. The first preset value may be, for example, 6 µm.

Here, an orthogonal projection of a pixel opening 132 on the substrate 110 (refer to FIG. 4) is located within a range of an orthogonal projection of a first avoidance opening 151 on the substrate 110 (refer to FIG. 4); and an orthogonal projection of a light-irradiating opening 131 on the substrate 110 (refer to FIG. 4) is located within a range of an orthogonal projection of a second avoidance opening 152 on the substrate 110 (refer to FIG. 4).

Here, referring to FIG. 11A, the shape of the first avoidance opening 151 and the shape of the pixel opening 132 may be substantially the same, for example; the shape of the second avoidance opening 152 and the shape of the light-irradiating opening 131 may be substantially the same, for example.

An average distance between a boundary of the orthogonal projection of the first avoidance opening 151 on the substrate 110 and a boundary of the orthogonal projection of the pixel opening 132 on the substrate 110 is in a range of 2 µm to 6 µm, inclusive, which is conducive to the design of the wide viewing angle of the display panel 100. For example, the average distance between the boundary of the orthogonal projection of the first avoidance opening 151 on the substrate 110 and the boundary of the orthogonal projection of the pixel opening 132 on the substrate 110 is any one of 2 µm, 4 µm and 6 µm.

A distance between a boundary of the orthogonal projection of the second avoidance opening 152 on the substrate 110 and a boundary of the orthogonal projection of the light-irradiating opening 131 on the substrate 110 is in a range of 0 µm to 3.2 µm, inclusive, as long as the second avoidance opening 152 will not block the light-irradiating opening 131. For example, the distance between the boundary of the orthogonal projection of the second avoidance opening 152 on the substrate 110 and the boundary of the orthogonal projection of the light-irradiating opening 131 on the substrate 110 is any one of 0 µm, 0.2 µm, 1 µm, 1.9 µm, 3 µm and 3.2 µm.

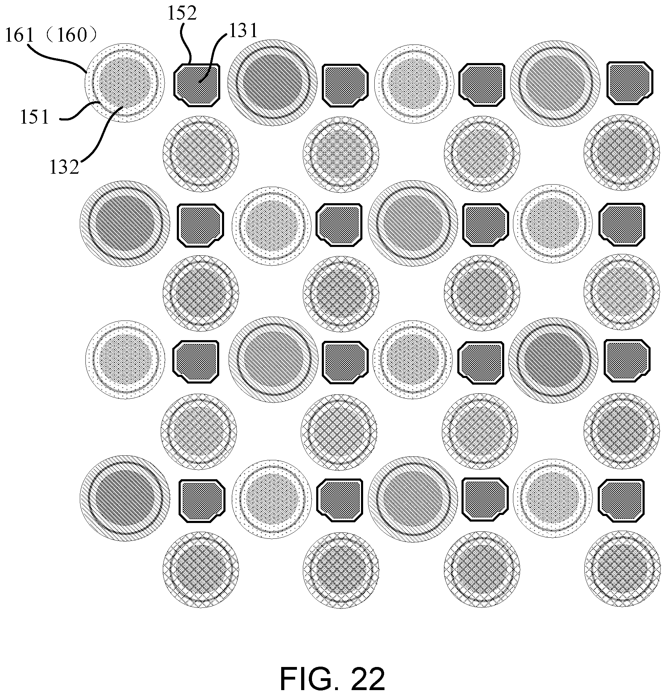

In some embodiments, referring to FIG. 4 and FIG. 22, the display panel 100 further includes a color film 160, and the color film 160 is arranged on the side of the pixel defining layer 140 away from the substrate 110. Here, in a case where the display panel 100 includes the black matrix 150, the color film 160 is arranged on a side of the black matrix 150 away from the substrate 110.

It will be noted that the color film 160 can filter out most of the wavelength bands of ambient light, thereby reducing the reflection intensity of the ambient light on the display panel 100.

Here, as shown in FIG. 4 and FIG. 22, the color film 160 includes a plurality of filter patterns 161, and an orthogonal projection of a pixel opening 132 on the substrate 110 is located within a range of an orthographic projection of a filter pattern 161 on the substrate 110.

A distance between a boundary of the orthographic projection of the filter pattern 161 on the substrate 110 and a boundary of the orthogonal projection of the first avoidance opening 151 on the substrate 110 is greater than or equal to 4.5 µm, so that the filter pattern 161 has a high adhesiveness to the black matrix 150, which reduces the risk of the filter pattern 161 falling off from the black matrix 150.

In addition, a distance between the boundary of the orthographic projection of the filter pattern 161 on the substrate 110 and a boundary of the orthogonal projection of the light-irradiating opening 131 on the substrate 110 is greater than or equal to 0 µm. For example, the distance between the boundary of the orthographic projection of the filter pattern 161 on the substrate 110 and the boundary of the orthogonal projection of the light-irradiating opening 131 on the substrate 110 is in a range of 0 µm to 1.8 µm, inclusive. For example, the distance between the boundary of the orthographic projection of the filter pattern 161 on the substrate 110 and the boundary of the orthogonal projection of the light-irradiating opening 131 on the substrate 110 is any one of 0 µm, 0.4 µm, 0.8 µm, 0.9 µm, 1.4 µm, 1.6 µm and 1.8 µm.

Here, referring to FIG. 22, the shape of the filter pattern 161 may be substantially the same as the shape of the pixel opening 132, or may be different from the shape of the pixel opening 132. FIG. 22 shows an example in which the shape of the filter pattern 161 is substantially the same as the shape of the pixel opening 132.

It will be noted that a material of the filter pattern 161 includes an organic material, for example, a material of a filter portion 530 includes at least one of poly methyl methacrylate, general purpose polymers of polystyrene, polymer derivatives with phenolic groups, acryloyl polymers, imide polymers, aryl ether polymers, amide polymers, fluorine polymers, parylene polymers, or vinyl alcohol polymers.

In some embodiments, referring to FIG. 11A and FIG. 12, the display panel 100 further includes a spacer 17, and the spacer 17 is arranged on the side of the pixel defining layer 130 away from the substrate 110 (refer to FIG. 4).

For example, the display panel 100 includes the black matrix 150, and the spacer 170 may be arranged between the pixel defining layer 130 and the black matrix 150.

It will be noted that the spacer 170 can be used to support a mask during the process, so that s gap between the mask and the pixel defining layer 130 is uniform.

The foregoing descriptions are merely specific implementations of the present disclosure, but the scope of protection of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a substrate;
a driving circuit layer arranged on the substrate, an orthographic projection of the driving circuit layer on the substrate defining a plurality of light-transmissive zones; and
a pixel defining layer arranged on a side of the driving circuit layer away from the substrate, wherein the pixel defining layer is provided therein with a plurality of light-irradiating openings; and an orthogonal projection of a light-irradiating opening on the substrate is located in a light-transmissive zone, and a shape of the orthogonal projection of the light-irradiating opening on the substrate is substantially same as a shape of the light-transmissive zone.

2. The display panel according to claim 1, wherein the driving circuit layer includes:
a plurality of pixel circuits arranged in multiple rows and multiple columns, wherein a row of pixel circuits is divided into a plurality of pixel circuit groups, and a pixel circuit group includes two adjacent pixel circuits; and in a same pixel circuit group, two pixel circuits are substantially symmetrical about a first axis line, the first axis line extends along a first direction, and the first direction is a column direction in which the plurality of pixel circuits are arranged; and
a plurality of data lines substantially extending along the first direction, wherein the plurality of data lines are divided into a plurality of data line groups, and a data line group includes two adjacent data lines; and the two data lines in the data line group are respectively electrically connected to two pixel circuits in a pixel circuit group, wherein
the light-transmissive zone is located between two data lines in a same data line group, and the light-irradiating opening is substantially parallel to opposite edges of orthographic projections of first set line segments of the two data lines in the same data line group on the substrate.

3. The display panel according to claim 2, wherein the data lines each include first straight line segments and first bent segments that are alternately connected, and in the same data line group, first bent segments of the two data lines are bent toward directions away from each other; and the first set line segments each include at least a portion of a first bent segment.

4. The display panel according to claim 3, wherein the first bent segment includes a first data trace segment, a second data trace segment, and a third data trace segment that are connected in sequence, the first data trace segment and the third data trace segment are respectively connected to first straight line segments on both sides of the first bent segment, an extending direction of the second data trace segment is substantially same as an extending direction of the first straight line segments, and the second data trace segment is farther away from first bent segments of another data line in the same data line group than the first straight line segments; and
the first set line segment includes a portion of the second data trace segment, and includes a portion of the first data trace segment or a portion of the third data trace segment.

5. The display panel according to any one of claims 1 to 4, wherein the driving circuit layer further includes:
first scanning signal lines extending substantially along a second direction; and
second scanning signal lines extending substantially along the second direction, wherein
the light-transmissive zone is located between a first scanning signal line and a second scanning signal line that are adjacent; and the light-irradiating opening is substantially parallel to opposite edges of an orthographic projection of a second set line segment of the first scanning signal line on the substrate, and the light-irradiating opening is substantially parallel to opposite edges of an orthographic projection of a third set line segment of the second scanning signal line on the substrate.

6. The display panel according to claim 5, wherein the first scanning signal line includes second straight line segments and second bent segments that are alternately connected, the second scanning signal line includes third straight line segments and third bent segments that are alternately connected, and a second bent segment and a third bent segment that are adjacent are bent toward directions away from each other; and
the second set line segment includes at least a portion of the second bent segment, and the third set line segment includes the third bent segment and a portion of the third straight line segment.

7. The display panel according to claim 6, wherein the second bent segment includes a first reset trace segment, a second reset trace segment, a third reset trace segment, a fourth reset trace segment, a fifth reset trace segment, a sixth reset trace segment, and a seventh reset trace segment that are connected in sequence, wherein
the first reset trace segment and the seventh reset trace segment are respectively connected to second straight line segments on both sides of the second bent segment; an extending direction of the second reset trace segment, the fourth reset trace segment and the sixth reset trace segment is substantially same as an extending direction of the second straight line segments, and the second reset trace segment and the sixth reset trace segment are farther away from the second scanning signal line than the second straight line segments; the fourth reset trace segment is farther away from the adjacent second scanning signal line than the second reset trace segment and the sixth reset trace segment; and
the second set line segment includes the fourth reset trace segment, a portion of the third reset trace segment, and a portion of the fifth reset trace segment.

8. The display panel according to claim 6 or 7, wherein the third bent segment includes a first scanning trace segment, a second scanning trace segment, and a third scanning trace segment, wherein
the first scanning trace segment and the third scanning trace segment are respectively connected to third straight line segments on both sides of the third bent segment, and an extending direction of the second scanning trace segment is substantially same as an extending direction of the third straight line segments, and the second scanning trace segment is farther away from the adjacent first scanning signal line than the third straight line segments.

9. The display panel according to any one of claims 1 to 8, wherein a minimum distance between a boundary of the orthogonal projection of the light-irradiating opening on the substrate and a boundary of the light-transmissive zone is greater than or equal to 1 µm.

10. The display panel according to any one of claims 1 to 9, wherein the pixel defining layer is further provided therein with a plurality of pixel openings, and the plurality of pixel openings include a plurality of first pixel openings, a plurality of second pixel openings, a plurality of third pixel openings, and a plurality of fourth pixel openings, wherein
the plurality of first pixel openings and the plurality of second pixel openings are arranged in an array in multiple rows and multiple columns, each row includes multiple first pixel openings and multiple second pixel openings that are arranged alternately along a second direction, and each column includes multiple first pixel openings and multiple second pixel openings that are arranged alternately along a first direction; and
the plurality of third pixel openings and the plurality of fourth pixel openings are arranged in an array in multiple rows and multiple columns, each row includes multiple third pixel openings and multiple fourth pixel openings that are arranged alternately along the second direction, and each column includes multiple third pixel openings and multiple fourth pixel openings that are arranged alternately along the first direction; and a third pixel opening is located between first pixel openings and second pixel openings that are arranged in two rows and two columns, and a fourth pixel opening adjacent thereto is located between first pixel openings and second pixel openings that are arranged in another two rows and two columns.

11. The display panel according to claim 10, wherein the light-irradiating opening is located between a first pixel opening and a second pixel opening that are adjacent in the second direction.

12. The display panel according to claim 11, wherein an orthogonal projection, on the substrate, of each of the first pixel opening, the second pixel opening, the third pixel opening, and the fourth pixel opening is substantially circular.

13. The display panel according to claim 12, wherein the light-transmissive zone includes a first folded edge, a first straight edge, a second folded edge, and a second straight edge that are connected in sequence; the first folded edge includes a plurality of first straight sub-edges connected in sequence, and the second folded edge includes a plurality of second straight sub-edges connected in sequence; and the first straight edge and the second straight edge are an edge closest to a third pixel opening adjacent to the light-transmissive zone and an edge closest to a fourth pixel opening adjacent to the light-transmissive zone, respectively;
the light-irradiating opening includes a third folded edge, a third straight edge, a fourth folded edge, and a fourth straight edge that are connected in sequence; the third folded edge is proximate to the first pixel opening and includes a plurality of third straight sub-edges connected in sequence; and the fourth folded edge is proximate to the second pixel opening and includes a plurality of fourth straight sub-edges connected in sequence; and
the third straight edge is substantially parallel to the first straight edge, and the fourth straight edge is substantially parallel to the second straight edge; the plurality of third straight sub-edges in the third folded edge are in one-to-one correspondence with and substantially parallel to the plurality of first straight sub-edges in the first folded edge; and a number of the plurality of fourth straight sub-edges in the fourth folded edge is less than a number of the plurality of second straight sub-edges in the second folded edge, and each fourth straight sub-edge is substantially parallel to a second straight sub-edge.

14. The display panel according to claim 11, wherein an orthogonal projection, on the substrate, of each of the first pixel opening, the third pixel opening, and the fourth pixel opening is substantially circular;
an outer contour of the second pixel opening includes a first curved edge and a second curved edge, both ends of the first curved edge are respectively connected to both ends of the second curved edge, and two connection points of the first curved edge and the second curved edge are a first connection point and a second connection point; and
a connection line between the first connection point and the second connection point is a first line segment; a length of the first line segment is a maximum dimension of the second pixel opening, and divides the second pixel opening into a first sub-portion including the first curved edge and a second sub-portion including the second curved edge; an area of the first sub-portion is greater than an area of the second sub-portion.

15. The display panel according to claim 14, wherein the light-transmissive zone includes a first folded edge, a first straight edge, a second folded edge, and a second straight edge that are connected in sequence; the first folded edge includes a plurality of first straight sub-edges connected in sequence, and the second folded edge includes a plurality of second straight sub-edges connected in sequence; and the first straight edge and the second straight edge are an edge closest to a third pixel opening adjacent to the light-transmissive zone and an edge closest to a fourth pixel opening adjacent to the light-transmissive zone, respectively;
the light-irradiating opening includes a third folded edge, a third straight edge, a fourth folded edge, and a fourth straight edge that are connected in sequence; the third folded edge is proximate to the first pixel opening and includes a plurality of third straight sub-edges connected in sequence; and the fourth folded edge is proximate to the second pixel opening and includes a plurality of fourth straight sub-edges connected in sequence;
the third straight edge is substantially parallel to the first straight edge, and the fourth straight edge is substantially parallel to the second straight edge; the plurality of third straight sub-edges in the third folded edge are in one-to-one correspondence with and substantially parallel to the plurality of first straight sub-edges in the first folded edge; and each fourth straight sub-edge is substantially parallel to a second straight sub-edge; and
in a case where the fourth folded edge is opposite to the second curved edge of the second pixel opening, the plurality of fourth straight sub-edges in the fourth folded edge are in one-to-one correspondence with the plurality of second straight sub-edges in the second folded edge; and in a case where the fourth folded edge is non-opposite to the second curved edge of the second pixel opening, a number of the plurality of fourth straight sub-edges in the fourth folded edge is less than a number of the plurality of second straight sub-edges in the second folded edge.

16. The display panel according to any one of claims 11 to 15, further comprising:
a touch layer arranged on a side of the pixel defining layer away from the substrate, wherein the touch layer includes a plurality of touch lines, and an orthographic projection of the plurality of touch lines on the substrate is staggered from an orthogonal projection of the pixel openings and the light-irradiating openings on the substrate; and the plurality of touch lines are arranged crosswise to form a mesh structure, wherein
there exists at least such one row of light-irradiating openings that there is no touch line between the row of light-irradiating openings and both first pixel openings and second pixel openings adjacent thereto in the second direction.

17. The display panel according to claim 16, wherein first pixel openings and second pixel openings in a same row are divided into a plurality of pixel opening groups, and each pixel opening group includes a first pixel opening and a second pixel opening that are adjacent; and
in a same pixel opening group, a first pixel opening and a second pixel opening is provided therebetween with a touch line; and there is no touch line between a first pixel opening and a second pixel opening that are adjacent and belong to different pixel opening groups in the second direction.

18. The display panel according to claim 16 or 17, wherein in a case where there is no touch line between a light-irradiating opening and a pixel opening, a distance between the light-irradiating opening and the pixel opening is a first distance; in a case where there is a touch line between a light-irradiating opening and a pixel opening, a distance between the light-irradiating opening and the pixel opening is a second distance; and the first distance is less than the second distance.

19. The display panel according to any one of claims 11 to 18, further comprising:
a black matrix arranged on a side of the pixel defining layer away from the substrate, wherein the black matrix is provided therein with a plurality of first avoidance openings and a plurality of second avoidance openings, wherein
an orthogonal projection of a pixel opening on the substrate is located within a range of an orthogonal projection of a first avoidance opening on the substrate; and an orthogonal projection of a light-irradiating opening on the substrate is located within a range of an orthogonal projection of a second avoidance opening on the substrate.

20. The display panel according to claim 19, wherein
an average distance between a boundary of the orthogonal projection of the first avoidance opening on the substrate and a boundary of the orthogonal projection of the pixel opening on the substrate is in a range of 2 µm to 6 µm, inclusive; and/or
a distance between a boundary of the orthogonal projection of the second avoidance opening on the substrate and a boundary of the orthogonal projection of the light-irradiating opening on the substrate is in a range of 0 µm to 3.2 µm, inclusive.

21. The display panel according to claim 19 or 20, wherein a distance between the first avoidance opening and the second avoidance opening is greater than or equal to a first preset value, and the first preset value is a process limit value allowing the first avoidance opening to be separated from the second avoidance opening.

22. The display panel according to any one of claims 19 to 21, further comprising:
a color film arranged on a side of the black matrix away from the substrate, wherein the color film includes a plurality of filter patterns, and the orthogonal projection of the pixel opening on the substrate is located within a range of an orthographic projection of a filter pattern on the substrate, wherein
a distance between a boundary of the orthographic projection of the filter pattern on the substrate and a boundary of the orthogonal projection of the first avoidance opening on the substrate is greater than or equal to 4.5 µm.

23. A display apparatus, comprising:
the display panel according to any one of claims 1 to 22, the display panel including a light-exit side and a non-light-exit side arranged opposite thereto; and
a photosensitive device arranged on the non-light-exit side of the display panel.
